# EUROPÄISCHE PATENTSCHRIFT

(11) **EP 3 764 458 B1**
(45) Veröffentlichungstag und Bekanntmachung des Hinweises auf die Patenterteilung: **28.12.2022**
(21) Anmeldenummer: 20161133.2
(22) Anmeldetag: 05.03.2020
(51) Int. Cl.: H01P 3/16, H01P 5/08, H05K 1/11, H01R 12/53

(54) **ANSCHLUSSVERBINDUNG MIT EINER HYBRIDKABELANORDNUNG UND EINER LEITERPLATTENANORDNUNG**
CONNECTION WITH A HYBRID CABLE ARRANGEMENT AND A CIRCUIT BOARD ARRANGEMENT
CONNEXION DOTÉ D'UN AGENCEMENT DE CÂBLE HYBRIDE ET D'UN AGENCEMENT DE CARTE DE CIRCUIT IMPRIMÉ

(30) Priorität: 10.07.2019 DE 102019118733
(43) Veröffentlichungstag der Anmeldung: 13.01.2021
(73) Patentinhaber: MD Elektronik GmbH, 84478 Waldkraiburg (DE)
(72) Erfinder: Huber, Martin, 83119 Obing (DE)

(56) Entgegenhaltungen:
- EP-A1- 3 435 482
- US-A1- 2016 006 101

## Beschreibung

Die Erfindung betrifft eine Anschlussverbindung mit einer Hybridkabelanordnung und einer Leiterplattenanordnung.

Es besteht der Wunsch, Daten mit einer immer höheren Datenübertragungsrate zu übertragen. Beispielsweise erzeugen heute Sensoren, die in Fahrzeugen verbaut sind und die die Fahrzeugumgebung abtasten, sehr hohe Datenraten. Diese Daten werden Assistenzsystemen zugeführt, die teilweise in die Fahrzeugsteuerung regelnd eingreifen bzw. diese in bestimmten Situationen auch übernehmen können (z.B. Notbremsassistent). In der Zukunft werden, insbesondere im Zusammenhang mit dem Wunsch nach einem autonomen Fahren, noch höhere Datenraten notwendig sein. Um diese zu erreichen sind entsprechende Kabel notwendig.

Aus der US 2016/006101 A1 ist eine Verbindung zwischen zwei Steuereinheiten bekannt, die in einem Gehäuse angeordnet sind. Die Steuereinheiten sind zur Datenübertragung über ein Kabel miteinander verbunden. Dieses Kabel umfasst einen dielektrischen Wellenleiter. Weiterhin umfasst das Kabel elektrische Leiter. Um eine Abwärtskompatibilität sicherzustellen, muss die Steckverbindung die Ausmaße eines RJ11 Steckers haben.

Nachteilig an der US 2016/006101 A1 ist, dass ein relativ großer Bauraum benötigt wird, um die Anschlussverbindungen zu integrieren.

Aus der EP 3 435 482 A1 ist eine weitere Verbindung bekannt, wodurch ein Kabel, insbesondere ein Koaxialkabel, mit einer Leiterplatte elektrisch und mechanisch verbunden werden kann. Die Leiterplatte weist dabei eine seitliche Ausnehmung auf, in die ein Ende des Kabels zur elektrischen und mechanischen Verbindung mit der Leiterplatte eingeführt wird. Das Kabel umfasst jedoch nur elektrische Leiter und keinen dielektrischen Wellenleiter.

Aufgabe der hier vorliegenden Erfindung ist es daher, eine Anschlussverbindung zu schaffen, die sehr kompakt aufgebaut ist und dennoch sehr hohe Datenraten zulässt. Diese Aufgabe wird durch die Anschlussverbindung des unabhängigen Anspruches 1 gelöst. In den Unteransprüchen sind vorteilhafte Weiterbildungen der erfindungsgemäßen Anschlussverbindung beschrieben.

Die Anschlussverbindung umfasst eine Hybridkabelanordnung und eine Leiterplattenanordnung. Die Leiterplattenanordnung weist dabei eine erste und eine zweite Außenlageanordnung und eine Zwischenlageanordnung auf, die aufeinander gestapelt angeordnet und insbesondere mit¬ein¬ander verklebt und/oder verpresst sind. Die erste bzw. zweite Außenanlageanordnung umfasst zumindest eine Lage, die elektrisch leitfähig ist. Die Hybridkabelanordnung umfasst ein dielektrisches Wellenleitersystem, um eine Radarwelle im Frequenzbereich von mehr als ca. 70 GHz bis maximal ca. 300 GHz, insbesondere ca. 80 GHz bis ca. 150 GHz übertragen zu können. Über ein dielektrisches Wellenleitersystem soll daher keine elektromagnetische Strahlung im Spektrum von IR bis UV übertragen werden (sog. Radarwellen). Das dielektrische Wellenleitersystem umfasst einen Kern und eine Hülle, die sich beide in Längsrichtung erstrecken, wobei die Hülle den Kern umgibt. Kern und Hülle weisen in dem oben angegebenen Frequenzbereich von 70 bis 300 GHz, insbesondere von 80 bis 150 GHz, deutlich unterschiedliche Dielektrizitätskonstanten auf, so dass an der den Kern umlaufenden Grenzfläche zu der Hülle eine Totalreflexion der elektromagnetischen Strahlung auftritt, die die elektromagnetische Strahlung auf den Kern beschränkt, so dass die elektromagnetische Strahlung sich im Wesentlichen in Richtung der Erstreckung des Kerns ausbreitet. Insbesondere ist vorgesehen, dass der Kern und die Hülle unterschiedliche Materialien mit stark abweichenden Dielektrizitätskonstanten umfassen. Alternativ hierzu kann vorgesehen sein, dass der Kern und die Hülle aus chemisch dem gleichen Material bestehen, allerdings der Kern das Material in kompakter Form enthält und die Hülle das Material beispielsweise in geschäumter Form. Insbesondere kann für diese Alternative vorgesehen sein, dass der Kern aus einem Kunststoff in massiver, kompakter und dichter Form aufweist, die Hülle diesen Kunststoff allerdings in poröser, beispielsweise geschäumter Form. Die Hybridkabelanordnung umfasst außerdem ein erstes Leitersystem, über welches Energie und/oder Daten übertragen werden können. Das erste Leitersystem ist neben dem dielektrischen Wellenleitersystem, sich im Wesentlichen entlang der Erstreckungsrichtung des dielektrischen Wellenleitersystems erstreckend, insbesondere parallel zu dem dielektrischen Wellenleitersystem oder das dielektrische Wellenleitersystem wendelförmig oder schraubenförmig umgebend, angeordnet. Das erste Leitersystem umfasst eine elektrisch leitfähige Innenleiteranordnung, die von einem elektrisch isolierenden Mantel umgeben ist. Die Leiterplattenanordnung umfasst zwischen der ersten und zweiten Außenlageanordnung eine erste Ausnehmung, durch welche ein Kabelaufnahmeraum gebildet ist. Der Kabelaufnahmeraum ist an einem ersten Seitenrand der Leiterplattenanordnung gebildet und von außerhalb der Leiterplattenanordnung aus zugänglich. Die elektrisch leitfähige Innenleiteranordnung ist an dem ersten Seitenrand in den Kabelaufnahmeraum eingeführt und mit einem ersten Innenleiteranschlussbereich der Leiterplattenanordnung galvanisch verbunden. Zumindest der Kern, insbesondere auch die Hülle des zumindest einen dielektrischen Wellenleitersystems sind ebenfalls an dem ersten Seitenrand in den Kabelaufnahmeraum eingeführt und an einem Wellenleiteranschlussbereich der Leiterplattenanordnung angeordnet bzw. mit diesem gekoppelt.

Es ist besonders vorteilhaft, dass die erfindungsgemäße Anschlussverbindung sehr kompakt aufgebaut ist. So kann ein Hybridkabel aufgenommen werden, über welches sowohl elektromagnetische Signale (über das dielektrische Wellenleitersystem) als auch elektrische Signale (über das erste Leitersystem) übertragen werden können. Durch Einbringen der Ausnehmung in die Leiterplattenordnung selbst ist ein sehr flacher Aufbau möglich, wodurch die Anschlussverbindung auch in beengten Bauräumen, wie beispielsweise in Kraftfahrzeugen, eingesetzt werden kann.

Vorzugsweise umfasst die Leiterplattenanordnung einen Resonanzraum, der hornförmig ausgestaltet ist. Hierzu ist in der Leiterplattenanordnung ein zweiter Aufnahmeraum vorgesehen, an dessen erstem Ende eine Strahlerfläche angeordnet ist, die mit einem Computerchip verbunden ist, wobei das zweite Ende über eine Durchgangsöffnung mit dem Kabelaufnahmeraum unter Bildung des Wellenleiteranschlussbereichs verbunden ist. Der Computerchip selbst ist dabei ebenfalls innerhalb der Leiterplattenanordnung angeordnet, wodurch der gesamte Aufbau nochmals kompakter wird.

Vorzugsweise ist der Computerchip gehäuselos in die Leiterplattenanordnung integriert. Ein die elektrischen Bauteile tragendes Teil des Computerchips (das Die) kann daher direkt auf eine entsprechende Lage (der Zwischenlageanordnung) der Leiterplattenanordnung gesetzt werden, wobei über Bonddrähte die Anbindung des Computerchips sichergestellt wird. Über diese Bonddrähte wird ein Anschluss des Computerchips mit einer Kontaktierungsfläche, die wiederum galvanisch mit der Strahlerfläche verbunden ist, verbunden.

In einer bevorzugten Ausführungsform wird die elektrisch leitfähige Innenleiteranordnung des ersten Leitersystems mit dem ersten Innenleiteranschlussbereich der Leiterplattenanordnung elektrisch leitend befestigt, insbesondere beispielsweise verlötet. Hierzu umfasst die erste bzw. zweite Außenlageanordnung eine erste Innenleiterkontaktieröffnung. In diese wird entsprechendes Befestigungsmittel, insbesondere ein Lot eingebracht und speziell für das Lot wird durch Erhitzen die jeweilige erste bzw. zweite Außenlageanordnung mit der elektrisch leitfähigen Innenleiteranordnung galvanisch verbunden. Dieses galvanische Verbinden erfolgt insbesondere über die elektrisch leitfähige Lage der ersten bzw. zweiten Außenlageanordnung. Der Bereich, in welchem das Lot bzw. allgemeiner das Befestigungsmittel die jeweilige Außenlageanordnung kontaktiert, wird auch als Innenleiteranschlussbereich bezeichnet. Das Lot könnte auch auf die elektrisch leitfähige Innenleiteranordnung aufgebracht werden, entsprechend könnte ein anderes Befestigungsmittel auch auf die elektrisch leitfähige Innenleiteranordnung aufgebracht werden.

Alternativ dazu kann die Kontaktierung auch lösbar erfolgen. In diesem Fall können die Hybridkabelanordnung und die Leiterplattenanordnung auch wieder voneinander getrennt werden. Hierzu umfasst die Leiterplattenanordnung eine Gehäuseanordnung, die zumindest ein Federelement aufweist, welches dafür sorgt, dass eine elektrische Kontaktierung dauerhaft kraftbeaufschlagt ist. Die Gehäuseanordnung liegt an der ersten oder zweiten Außenlageanordnung auf. Das Federelement weist einen Kontaktierungsvorsprung auf, welcher elektrisch leitfähig ist und welcher über eine Öffnung in der ersten oder zweiten Außenlageanordnung in den Kabelaufnahmeraum eintaucht. In einer Ruhelage, also bevor die elektrisch leitfähige Innenleiteranordnung in den Kabelaufnahmeraum eingeschoben wird, steht der Kontaktierungsvorsprung in keinem elektrischen Kontakt zur Innenleiteranordnung (der Kontaktierungsvorsprung ist kontaktierungsfrei, also unter Belassung eines Abstandes, zu der Innenleiteranordnung angeordnet). Beim Einschieben der elektrisch leitfähigen Innenleiteranordnung, also in einer Kontaktierungslage, gelangt der Kontaktierungsvorsprung in galvanischen Kontakt mit der Innenleiteranordnung. Das Federelement wird dadurch ausgelenkt und biegt sich von der elektrisch leitfähigen Innenleiteranordnung des ersten Leitersystems weg. Der Kontaktierungsvorsprung drückt mittels der Federkraft des Federelements auf die Innenleiteranordnung, so dass ein reproduzierbarer und dauerhafter elektrischer Kontakt ermöglicht wird. Über den elektrisch leitfähigen Kontaktierungsvorsprung findet dann die elektrische Anbindung der Innenleiteranordnung an die Leiterplattenanordnung statt. Hierzu können beispielsweise das Federelement mit dem Kontaktierungsvorsprung einteilig ausgebildet sein, so dass der Kontaktierungsvorsprung ein Abschnitt des Federelementes ist, wobei das Federelement mindestens im Bereich des Kontaktierungsvorsprungs, insbesondere aber vollständig, elektrisch leitfähig ist. Der Kontaktierungsvorsprung könnte in das Federelement durch eine Tiefenprägung eingebracht sein, wobei ein Ende des Federelements (z.B. über eine Ultraschallschweißverbindung) mit einer entsprechend leitfähigen Lage der Zwischenlageanordnung galvanisch verbunden ist.

Alternativ können der Kontaktierungsvorsprung und das Federelement auch zweiteilig ausgebildet sein. Beispielsweise könnte der Kontaktierungsvorsprung, insbesondere in Form eines Kontaktierungsbolzens, in einer Öffnung des Federelements festgelegt, insbesondere eingepresst bzw. mit dem Federelement verpresst bzw. verschweißt sein. Ergänzend oder alternativ wäre es auch möglich, dass eine Hülse verwendet wird, die von einer durchgängigen Öffnung durchsetzt ist und die in die Öffnung der ersten oder zweiten Außenlageanordnung eingesetzt, insbesondere eingepresst ist. In dieser Hülse ist der Kontaktierungsbolzen angeordnet, wobei der Kontaktierungsbolzen vorzugsweise in der Hülse hin und her bewegbar ist. Wird der Kontaktierungsbolzen weiter in die Hülse eingedrückt, dann wird er aus dem anderen Ende herausgedrückt. Die Hülse, der Kontaktierungsbolzen und das von der Hülse und dem Kontaktierungsbolzen getrennt bereitgestellte Federelement könnten auch miteinander zu einer vorgefertigten Baueinheit verbunden, beispielsweise miteinander verpresst bzw. verschweißt sein, wobei sich bei Bewegung des Kontaktierungsbolzen auch die Hülse teilweise aus der Öffnung herausbewegt, wodurch das Federelement ausgelenkt wird.

Verschiedene Ausführungsbeispiele der Erfindung werden nachfolgend unter Bezugnahme auf die Zeichnungen beispielhaft beschrieben. Gleiche Merkmale weisen bei verschiedenen Ausführungsbeispielen dieselben Bezugszeichen auf. Die entsprechenden Figuren der Zeichnungen zeigen im Einzelnen:

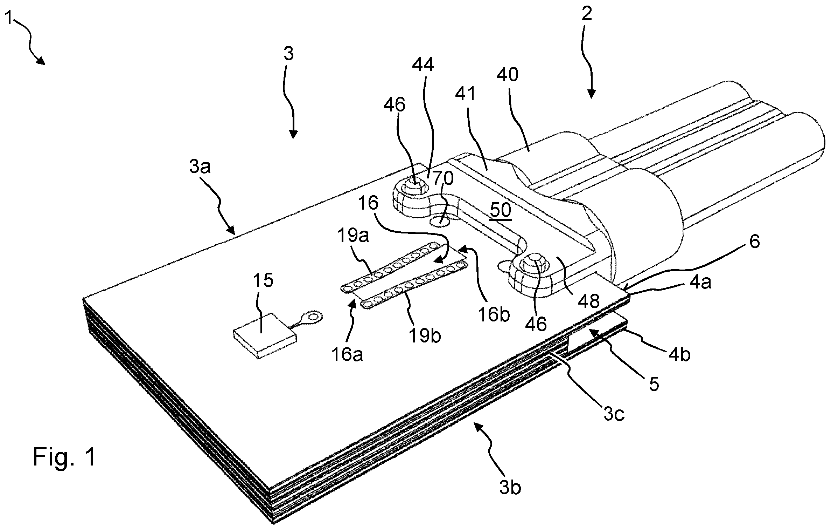

Figur 1: ein Ausführungsbeispiel der erfindungsgemäßen Anschlussverbindung;
Figuren 2A, 2B, 3:
   verschiedene Darstellungen einer Hybridkabelanordnung;
Figuren 4A, 4B, 4C:
   verschiedene Darstellungen einer Leiterplattenanordnung;
Figuren 4D, 5A, 5B:
   verschiedene Darstellungen eines Längsschnitts durch die erfindungsgemäße Anschlussverbindung;
Figuren 6A, 6B, 6C, 6D, 6E:
   verschiedene Darstellungen, die die Befestigung der Hybridkabelanordnung an der Leiterplattenanordnung näher beschreiben;
Figuren 7A, 7B, 7C, 7D, 7E:
   verschiedene Darstellungen, die die elektrische Kontaktierung der Hybridkabelanordnung an die Leiterplattenanordnung näher beschreiben;
Figuren 8A, 8B, 8C:
   verschiedene Darstellungen, die die elektrische Kontaktierung der Hybridkabelanordnung an die Leiterplattenanordnung näher beschreiben; und

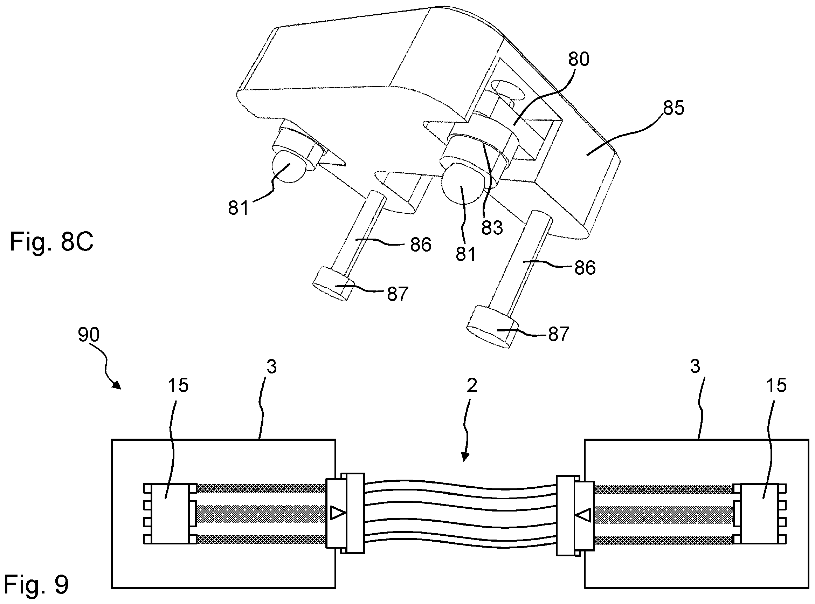

Figur 9: eine Darstellung eines Leiterplattenverbunds mit zwei Leiterplattenanordnungen, die über eine Hybridkabelanordnung miteinander verbunden sind.

Die erfindungsgemäße Anschlussverbindung 1 umfasst gemäß Figur 1 eine Hybridkabelanordnung 2 und eine Leiterplattenanordnung 3. Die Leiterplattenanordnung 3 umfasst eine erste Außenlageanordnung 3a, eine zweite Außenlageanordnung 3b und eine Zwischenlageanordnung 3c, die zwischen der ersten und der zweiten Außenlageanordnung 3a, 3b angeordnet ist. Die erste Außenlageanordnung 3a umfasst zumindest eine Lage 4a, die elektrisch leitfähig ist. Die zweite Außenlageanordnung 3b umfasst ebenfalls eine Lage 4b, die elektrisch leitfähig ist. Die Zwischenlageanordnung 3c umfasst optional einen Bereich, der aus einem dielektrischen Material besteht. Unter dem Begriff "Lageanordnung" wird ein Teil einer Leiterplatte verstanden, die eine oder mehrere Lagen umfassen kann. Die leitfähige Lage 4a, 4b muss nicht die äußerte Lage sein.

Die Leiterplattenanordnung 3 umfasst zwischen der ersten und zweiten Außenlageanordnung 3a, 3b eine erste Ausnehmung 5, wodurch ein Kabelaufnahmeraum 5 an einem ersten Seitenrand 6 der Leiterplattenanordnung 3 gebildet ist.

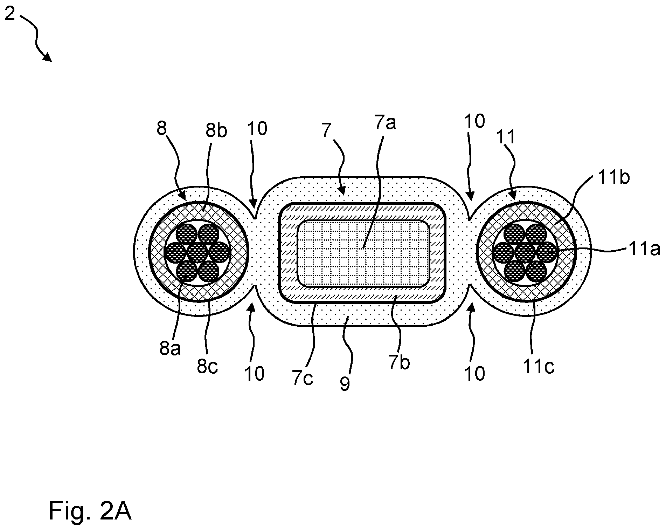

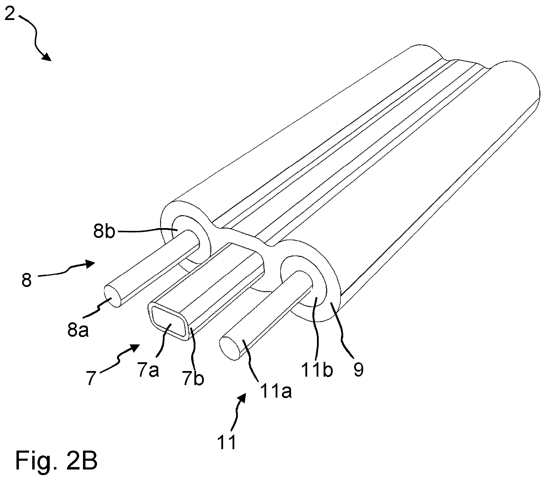

Die Hybridkabelanordnung 2 aus Figur 1 ist in den Figuren 2A und 2B genauer dargestellt. Die Hybridkabelanordnung 2 umfasst zumindest ein dielektrisches Wellenleitersystem 7 mit einem Kern 7a, der von einer Hülle 7b umgeben ist. Sowohl der Kern 7a als auch die Hülle 7b bestehen aus einem dielektrischen Material. Die dielektrische Leitfähigkeit (Dielektrizitätskonstante) des Materials des Kerns 7a ist höher als die dielektrische Leitfähigkeit (Dielektrizitätskonstante) des Materials der Hülle 7b, wobei die Materialien bzw. Dielektrizitätskonstanten so aufeinander bezogen gewählt sind, dass an der umlaufenden, sich senkrecht zu der Papierebene erstreckenden Grenzfläche zwischen dem Kern 7a und der Hülle 7b eine Totalreflexion für elektromagnetische Strahlung im Frequenzbereich von ca. 70 bis maximal ca. 300 GHz, insbesondere im Frequenzbereich von ca. 80 bis ca. 150 GHz auftritt. Die Hülle 7b ist in diesem Ausführungsbeispiel noch von einer Schirmfolie 7c umgeben. Diese Schirmfolie 7c besteht aus einem nichtleitenden Material (z.B. Kunststoff, insbesondere PET (Polyethylenterephthalat), welches auf der Außen und/oder Innenseite mit einem elektrisch leitfähigen Metall versehen, insbesondere bedampft ist. Bei dem Metall handelt es sich insbesondere um Aluminium. Ergänzend und alternativ zu der Schirmfolie 7c könnte noch ein Schirmdrahtgeflecht um die Hülle 7b herum angeordnet sein.

Die Hybridkabelanordnung 2 umfasst ein erstes Leitersystem 8. Das erste Leitersystem 8 umfasst eine elektrisch leitfähige Innenleiteranordnung 8a, die vorzugsweise aus einem Draht oder mehreren Litzen (in diesem Fall sieben Litzen) besteht, wobei die Litzen auch miteinander verdrillt sein können. Die elektrisch leitfähige Innenleiteranordnung 8a ist von einem Mantel 8b umgeben, der wiederum von einer Schirmfolie 8c umgeben ist, die denselben Aufbau aufweisen kann wie die Schirmfolie 7c des dielektrischen Wellenleitersystems 7. Ergänzend oder alternativ zur Schirmfolie 8c kann ein Schirmdrahtgeflecht vorhanden sein. Der Mantel 8b ist aus einem elektrisch nichtleitenden Material hergestellt; bei der Ausbildung des ersten Leitersystems 8 als KoaxialKabel zur Datenübertragung besteht der Mantel 8b aus einem Dielektrikum.

Das dielektrische Wellenleitersystem 7 und das erste Leitersystem 8 sind vorzugsweise von einem gemeinsamen elektrisch nichtleitenden, isolierenden Außenmantel 9 umgeben. Dieser ist abschnittsweise auch zwischen dem zumindest einen Wellenleitersystem 7 und der ersten Leiteranordnung 8 angeordnet. Der elektrisch nichtleitende Außenmantel 9 umfasst im Bereich zwischen dem Wellenleitersystem 7 und der ersten Leiteranordnung 8 eine Einbuchtung 10, um die Hybridkabelanordnung 2 leichter auftrennen zu können.

In Figur 2A ist noch ein zweites Leitersystem 11 dargestellt, welches eine elektrisch leitfähige Innenleiteranordnung 11a aufweist, die von einem Mantel 11b und einer Schirmfolie 11c umgeben ist.

Der Kern 7a des dielektrischen Wellenleitersystems 7 weist im Querschnitt vorzugsweise eine rechteckige Außenkontur auf. Das Längenverhältnis der langen zu der kurzen Seite sollte vorzugsweise 2:1 sein, wobei Abweichungen hiervon von vorzugsweise weniger als 20%, 15%, 10% oder weniger als 5% zulässig sind. Die elektrisch leitfähige Innenleiteranordnung 8a weist vorzugsweise einen runden Querschnitt bzw. einen einer solchen runden Form angenäherte Querschnittskontur auf.

In Figur 2B ist der gemeinsame elektrisch nichtleitende Außenmantel 9 teilweise von einem Ende der Hybridkabelanordnung 2 abgezogen. Selbiges gilt auch für den Mantel 8b, 11b des ersten bzw. zweiten Leitersystems 8, 11.

Zumindest der Kern 7a des zumindest einen dielektrischen Wellenleitersystems 7 ist an dem ersten Seitenrand 6 in den Kabelaufnahmeraum 5 eingeführt. Er ist an einem Wellenleiteranschlussbereich 30 der Leiterplattenanordnung 3 angeordnet bzw. angekoppelt.

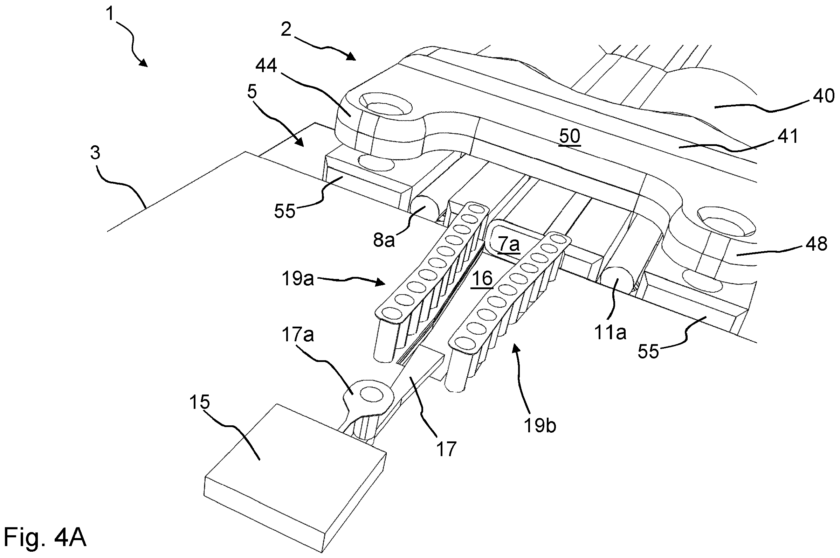

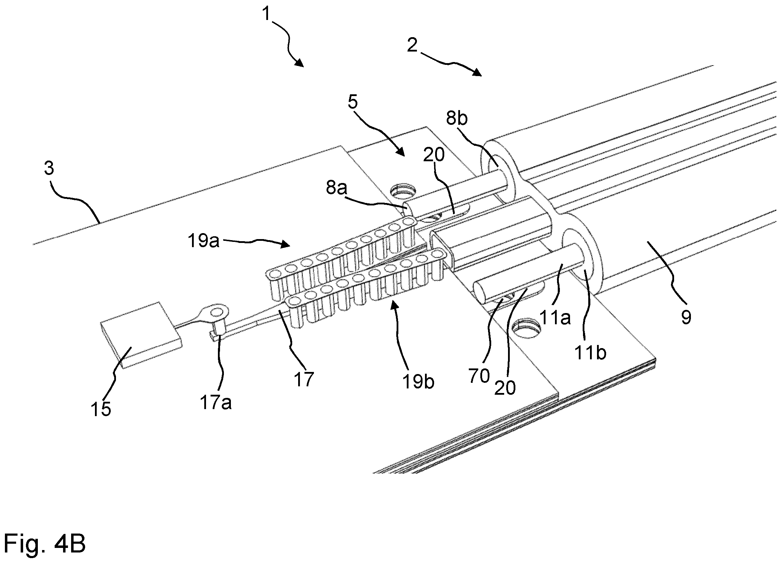

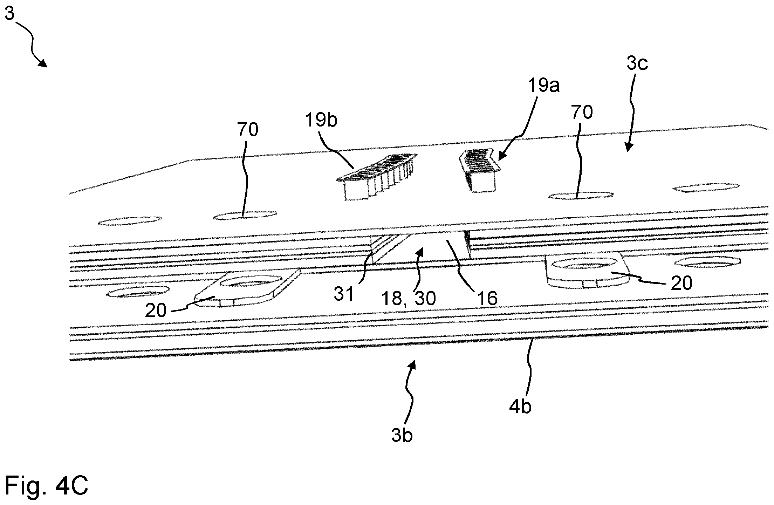

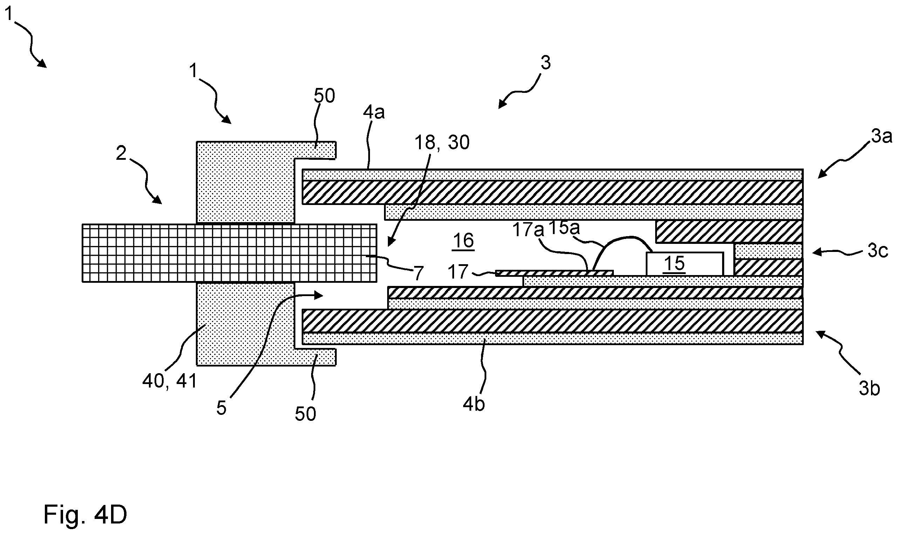

In Figur 1 ist ebenfalls ein Computerchip 15 dargestellt, der dazu ausgebildet ist, um über das zumindest eine dielektrische Wellenleitersystem 7 zu kommunizieren. Der Computerchip 15 ist auf der ersten Außenlageanordnung 3a angeordnet. Vorzugsweise ist er allerdings innerhalb der Leiterplattenanordnung 3 angeordnet. Hierzu wird auf Figur 4D verwiesen. Zwischen dem Computerchip 15 und dem Wellenleitersystem 7 ist ein Resonanzraum 16 vorgesehen. Hierzu umfasst die Leiterplattenanordnung 3 zwischen der ersten und zweiten Außenlageanordnung 3a, 3b eine zweite Ausnehmung, durch die der Resonanzraum 16 gebildet ist. Es wird auf die Figuren 4A, 4B, 4C und 4D verwiesen. An einem ersten Ende 16a des Resonanzraums 16 ist eine Strahlerfläche 17 angeordnet, die sich über eine Teillänge des Resonanzraums 16 erstreckt. Die Strahlerfläche 17 ist auch mit einem Anschluss des Computerchips 15 verbunden. Das zweite Ende 16b des Resonanzraums 16 ist über eine Durchgangsöffnung 18 mit dem Kabelaufnahmeraum 5 verbunden. Diese Durchgangsöffnung 18 stellt auch den Wellenleiteranschlussbereich 30 dar. Der Resonanzraum 16 verbindet das Wellenleitersystem 7 mit dem Computerchip 15 in dem Sinne, dass elektromagnetische Strahlung, die aus dem Wellenleitersystem 7 austritt, den Resonanzraum 16 durchsetzt und auf den Computerchip 15 trifft.

Der Resonanzraum 16 vergrößert sich vom ersten Ende 16a hin zum zweiten Ende 16b. Der Resonanzraum 16 ist nach oben zumindest durch die elektrisch leitfähige Lage 4a der ersten Außenlageanordnung 3a begrenzt. Nach unten ist er zumindest durch die elektrisch leitfähige Lage 4b der zweiten Außenlageanordnung 3b begrenzt. Zur ersten und zur zweiten Seite hin ist er durch eine erste Reihe von Durchkontaktierungen 19a und zur zweiten Seite hin durch eine zweite Reihe von Durchkontaktierungen 19b begrenzt. Diese durchsetzen vorzugsweise die gesamte Leiterplattenanordnung 3 und sind insbesondere mit den elektrisch Leitfähigen Lagen 4a, 4b der ersten und zweiten Außenlageanordnung 3a, 3b galvanisch verbunden. Sie sind bezogen auf die Frequenz unmittelbar beabstandet zueinander angeordnet, wobei ein Abstand zwischen zwei Durchkontaktierungen kleiner ist als λ/2 der Radarwelle. Ein Abstand der Durchkontaktierungen 19a der ersten Reihe zu den Durchkontaktierungen 19b der zweiten Reihe nimmt von dem ersten Ende 16a hin zu dem zweiten Ende 16b stetig zu, so dass in Draufsicht auf den Resonanzraum 16 eine als "Horn" bekannte Umgrenzung entsteht, so dass die Leiterplattenanordnung 3 einen hornförmig ausgestalteten Resonanzraum 16 aufweist. Die hornförmige Ausgestaltung des Resonanzraums 16 bewirkt eine seitliche Fokussierung der elektromagnetischen Strahlung in dem Resonanzraum 16 hin zu dem Computerchip 15.

Der Resonanzraum 16 ist in dem Ausführungsbeispiel als Hohlraum dargestellt, der oben und unten durch die elektrisch leitfähigen Lagen 4a, 4b der Außenlageanordnungen 3a, 3b der Leiterplattenanordnung 3 begrenzt ist sowie seitlich durch die beiden Reihen der Durchkontaktierungen 19a, 19b. In einer Abwandlung des dargestellten Ausführungsbeispiels kann der Resonanzraum 16 nicht als Hohlraum, sondern mit einem dielektrischen Material gefüllt ausgebildet sein; als Material für die Füllung des Resonanzraums 16 ist insbesondere ein Material geeignet, das dem Material des Kerns 7a des dielektrischen Wellenleitersystems 7 entspricht; alternativ hierzu kommt als Material für die Füllung des Resonanzraums ein Kunststoff wie PE (Polyethylen) oder PP (Polypropylen) in Frage. Die genannten Materialien für die Füllung des Resonanzraums 16 können bevorzugt in geschäumter Form in den Resonanzraum 16 eingebracht sein.

In Figur 4D ist der Computerchip 15 in dem Resonanzraum 16 angeordnet dargestellt. Der Computerchip 15 ist vorzugsweise gehäuselos innerhalb der Leiterplattenanordnung 3 angeordnet. Über Bonddrähte 15a ist ein Anschluss des Computerchips 15 mit einer Kontaktierungsfläche 17a, die insbesondere mit der Strahlerfläche 17 verbunden oder Teil dieser ist, galvanisch verbunden.

Der Computerchip 15 könnte auch in einem separaten Aufnahmeraum, welcher durch eine dritte Ausnehmung innerhalb der Leiterplattenanordnung 3 gebildet ist, angeordnet sein. Vorzugsweise wird die Leiterplattenanordnung 3 in zwei Hälften hergestellt. Eine Hälfte wird mit dem Computerchip 15 versehen, um anschließend beide Hälften aufeinander zu setzten und miteinander zu verschrauben und/oder zu verkleben und/oder zu verpressen.

In den Figuren 4A, 4B und 4C ist zumindest die erste Außenlageanordnung 3a entfernt. Deshalb steht die erste und zweite Reihe von Durchkontaktierungen 19a, 19b hervor.

Der Kern 7a des dielektrischen Wellenleitersystems 7 kann in den Resonanzraum 16 hineinragen und eine Begrenzungswandung 31 des Resonanzraums 16 nach innen, in den Resonanzraum 16 hin, durchsetzen. Vorzugsweise durchsetzt der Kern 7a des dielektrischen Wellenleitersystems 7 die Begrenzungswandung 31 des Resonanzraums 16 nicht, sondern endet beabstandet zu dieser Begrenzungswandung 31, insbesondere mit einem Abstand mehr als 1 mm, 2 mm, 3 mm, aber vorzugsweise von weniger als 10 mm, 7 mm, 5 mm, 3 mm. Bevorzugt ist dabei vorgesehen, wenn das Ende des Kerns 7a des dielektrischen Wellenleitersystems 7 an dem zweiten Ende 16b des Resonanzraums 16 im Wesentlichen bündig anliegt, mit einem Versatz von nicht mehr als ca. 1 bis 10 mm, insbesondere nicht mehr als ca. 1 bis 3 mm.

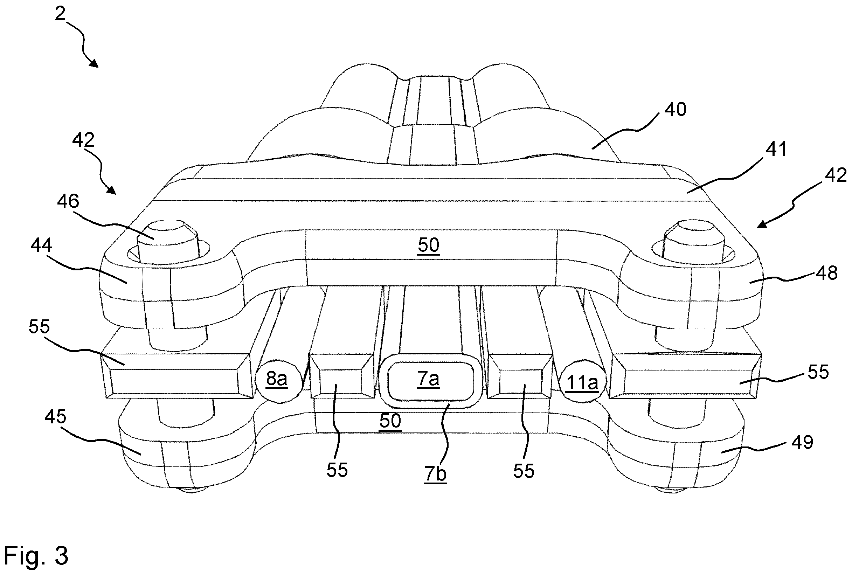

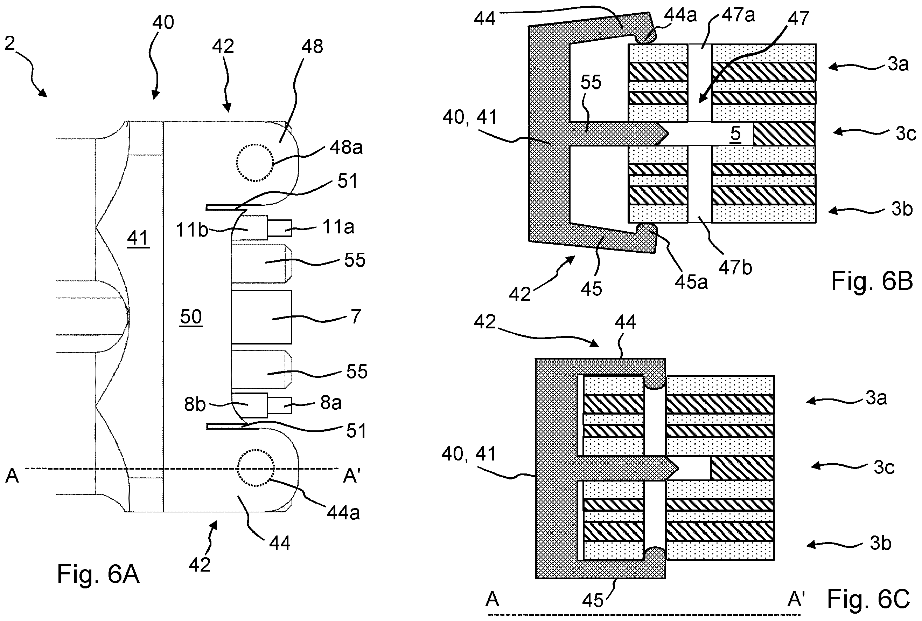

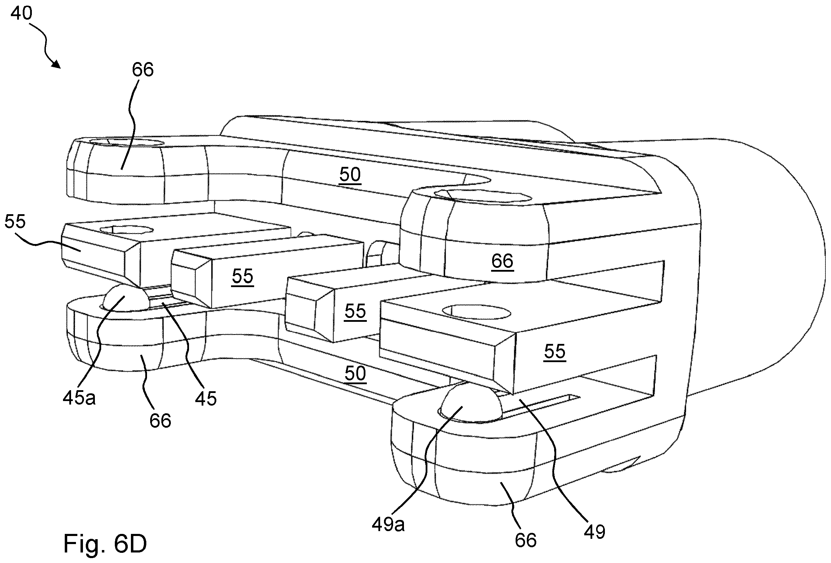

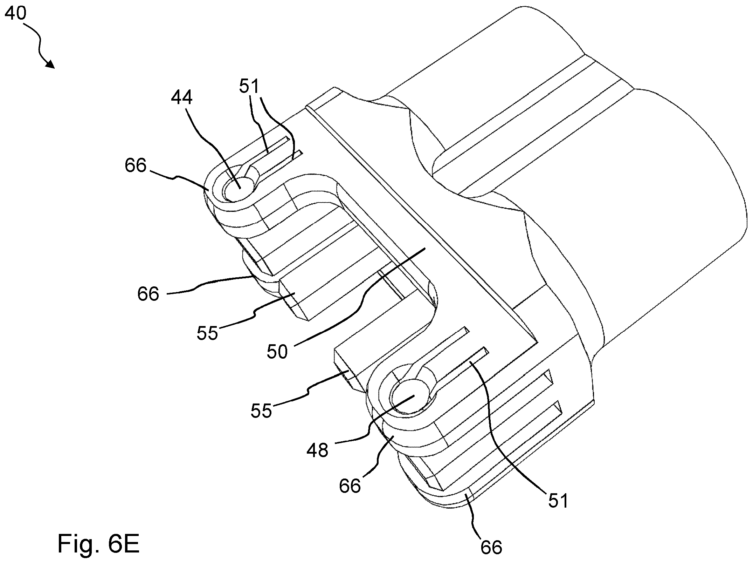

In den Figuren 6A, 6B, 6C, 6D und 6E wird erläutert, wie die Hybridkabelanordnung 2 an der Leiterplattenanordnung 3 befestigt werden kann. In diesem Zusammenhang wird auch Bezug auf die Figuren 1 und 3 genommen.

Die Hybridkabelanordnung 2 umfasst eine Kabelsammel und Ausrichteinrichtung 40, die aus einem Kunststoff besteht oder ein Kunststoffteil umfasst. Die Kabelsammel und Ausrichteinrichtung 40 weist einen Grundkörper 41 auf. Die Kabelsammel und Ausrichteinrichtung 40 ist unverschiebbar an dem zumindest einen dielektrischen Wellenleitersystem 7 und dem ersten bzw. zweiten Leitersystem 8, 11 angeordnet bzw. angespritzt. Die Kabelsammel und Ausrichteinrichtung 40 umfasst eine Befestigungseinrichtung 42, die an dem Grundkörper 41 ausgebildet ist. Sie steht vorzugsweise von dem Grundkörper 41 ab. Die Befestigungseinrichtung 42 ist dazu ausgebildet, die Kabelsammel und Ausrichteinrichtung 40 derart an der Leiterplattenanordnung 3 zu befestigen, dass das dielektrischen Wellenleitersystem 7 und das erste bzw. zweite Leitersystem 8, 11 lageunveränderlich in dem Kabelaufnahmeraum 5 angeordnet sind.

Die Befestigungseinrichtung 42 umfasst in dem Ausführungsbeispiel gemäß den Figuren 6A bis 6C eine erste und eine zweite Rastzunge 44, 45. Diese entspringen an verschiedenen Stellen des Grundkörpers 41. Die erste Rastzunge 44 verläuft in Richtung einer Oberseite der Leiterplattenanordnung 3, wobei die Oberseite durch die Oberfläche 4a der ersten Außenlageanordnung 3a gebildet ist. Die zweite Rastzunge 45 verläuft in Richtung einer Unterseite der Leiterplattenanordnung 3, wobei die Unterseite durch eine Oberfläche 4b der zweiten Außenlageanordnung 3b gebildet ist.

In Figur 1 ist eine unlösbare Verbindung dargestellt. In diesem Fall werden die erste und die zweite Rastzunge 44, 45 durch Bolzen 46 durchsetzt. Diese Bolzen durchsetzen auch die Leiterplattenordnung 3. Diese Bolzen werden vorzugsweise eingepresst. In den Figuren 6A bis 6C, sowie 6D und 6E ist eine lösbare Verbindung dargestellt. In diesem Fall umfasst die erste Rastzunge 44 einen Rastvorsprung 44a, der in ein erstes Ende 47a einer ersten Rastöffnung 47 eingreift. Die zweite Rastzunge 45 umfasst einen Rastvorsprung 45a, der in ein zweites Ende 47b der ersten Rastöffnung 47 an der zweiten Außenlageanordnung 3b eingreift. Die erste Rastöffnung 47 durchsetzt die Leiterplattenanordnung 3 vorzugsweise vollständig und wird durch einen Bohrprozess hergestellt. Die erste und die zweite Rastzunge 44, 45 sind in Draufsicht auf den Grundkörper 41 bevorzugt teilweise, insbesondere vollständig überlappend zueinander angeordnet. Vorzugsweise gibt es noch eine dritte und vierte Rastzunge 48, 49, die am anderen Ende des Grundkörpers 41 angeordnet sind. Zwischen der ersten und der dritten Rastzunge 44, 48 ist ein Verbindungssteg 50 angeordnet. Die erste und die dritte Rastzunge 44, 48 sind vorzugsweise durch einen Schlitz 51 von dem Verbindungssteg 50 getrennt, so dass sie federnde Eigenschaften haben. Gleiches gilt auch für die zweite und vierte Rastzunge 45, 49.

Der Verbindungssteg 50 liegt vorzugsweise auf der Oberseite der ersten Außenlageanordnung 3a an. Gleiches gilt auch für den Verbindungssteg 50 zwischen der zweiten und der vierten Rastzunge 45, 49. Dieser liegt auf der Oberseite der zweiten Außenlageanordnung 3b an.

Grundsätzlich wäre es auch möglich, dass lediglich die erste Rastzunge 44 zur Ausbildung der lösbaren Verbindung vorgesehen ist. Die erste Rastzunge 44 liegt dann an der ersten oder zweiten Außenlageanordnung 3a, 3b an und greift in die erste Rastöffnung 47 ein. Auf der gegenüberliegenden zweiten oder ersten Außenlagenanordnung 3b, 3a liegt dann ein Halteelement 66 an, welches später noch beschrieben wird. Alternativ oder ergänzend kann sich der gegenüberliegende Verbindungssteg 50 weiter in Richtung der Leiterplattenanordnung 3 erstrecken, sodass ein Umklammern der Leiterplattenanordnung 3 stattfindet.

Die Befestigungseinrichtung 40 umfasst zumindest einen Zentrierungssteg 55, der vom Grundkörper 41 aus in Richtung der Leiterplattenanordnung 3 verläuft und in dem Kabelaufnahmeraum 5 endet. Der zumindest eine Zentrierungssteg 55 ist zwischen dem zumindest einen dielektrischen Wellenleitersystem 7 und dem ersten Leitersystem 8 angeordnet. In Figur 3 gibt es eine Vielzahl von Verbindungsstegen 55, die auf beiden Seiten zwischen dem jeweiligen ersten bzw. zweiten Leitersystem 8, 11 angeordnet sind. Sie können sich hinsichtlich ihrer Breite unterscheiden. Die Zentrierungsstege 55 verjüngen sich vorzugsweise in Richtung ihres freien Endes, damit das Einführen der Zentrierungsstege 55 in den Kabelaufnahmeraum 5 vereinfacht ist.

In einem anderen Ausführungsbeispiel, welches in den Figuren 6D und 6E beschrieben ist, sind die Rastzungen 44, 45, 48, 49 teilweise verschieden aufgebaut. Die Befestigungseinrichtung 42 umfasst zumindest eine erste Rastzunge 44, wobei die zumindest eine erste Rastzunge 44 wieder an dem Grundkörper 41 entspringt und federnd an diesem ausgebildet ist. Die zumindest eine erste Rastzunge 44 verläuft in Figur 6E in Richtung einer Oberseite der Leiterplattenanordnung 3, wobei die Oberseite durch eine Oberfläche 4a der ersten Außenlageanordnung 3a gebildet ist. In Figur 6D ist die Oberseite durch eine Oberfläche 4b der zweiten Außenlageanordnung 3b gebildet. Zumindest eine erste Rastöffnung 47 durchsetzt die Leiterplattenanordnung 3 (siehe Figur 6B). Die erste Rastzunge 44 umfasst einen Rastvorsprung 44a (beispielsweise) in Form einer Rastkugel, der in die erste Rastöffnung 47 eingreift. Die Befestigungseinrichtung 42 umfasst zumindest ein erstes Halteelement 66, welches an dem Grundkörper 41 entspringt und in Richtung einer Oberseite der Leiterplattenanordnung 3 verläuft. Die zumindest eine erste Rastzunge 44 (Figur 6E) ist in einer Ausnehmung des Halteelements 66 angeordnet und von dem zumindest einen ersten Halteelement 66 umgeben, wobei ein teilweise um die zumindest eine erste Rastzunge 44 umlaufender Schlitz 51 zwischen der zumindest einen ersten Rastzunge 44 und dem zumindest einen ersten Halteelement 66 ausgebildet ist, wodurch die zumindest eine erste Rastzunge 44 lediglich an dem Grundkörper 41 befestigt ist und gegenüber dem zumindest einen Halteelement 66 bewegbar ist. Über das Haltelement 66 kann ein flächiger Krafteintrag erfolgen, wohingegen über die zumindest eine Rastzunge 44 ein Abziehschutz realisiert wird. Die Figuren 6D und 6E unterscheiden sich dadurch, wo die Rastzungen 44, 45, 48, 49 angeordnet sind, also ob sie an der ersten oder zweiten Außenlageanordnung 3a, 3b anliegen. Vorzugsweise gibt es zumindest zwei Rastzungen 44, 45, 48, 49. Diese sind voneinander beabstandet und liegen an verschiedenen Außenlageanordnungen 3a, 3b an. Sie können auch an derselben Außenlageanordnung 3a, 3b anliegen und sind dann durch den Verbindungssteg 50 voneinander getrennt.

Die Kabelsammel und Ausrichteinrichtung 40 ist ein Kunststoffspritzteil. Die Schlitze 51 zwischen den Rastzungen 44, 45, 48, 49 und den jeweiligen Halteelementen 66 werden durch bewegliche Schieber im Kunststoffspritzverfahren eingebracht, wobei die Länge der Schlitze 51 durch Verschieben der Schieber frei wählbar ist, sodass die Federkonstante der Rastzungen 44, 45, 49, 50 einstellbar ist.

Grundsätzlich ist es auch möglich, dass die Befestigungseinrichtung 40 derart ausgestaltet ist, dass die Hybridkabelanordnung 2 nur in einer bestimmten Ausricht bzw. Winkellage mit der Leiterplattenanordnung 3 verbindbar ist. Hierzu können die Zentrierungsstege 55 bzw. das erste und/oder zweite Leitersystem 8, 11 bzw. die jeweilige Rastzunge 44, 45, 48, 49 eine codierte Form aufweisen, die zu einer entsprechend codierten GegenForm in der Leiterplattenanordnung 3 korrespondiert, so dass eine mechanische Codierung ausgebildet ist.

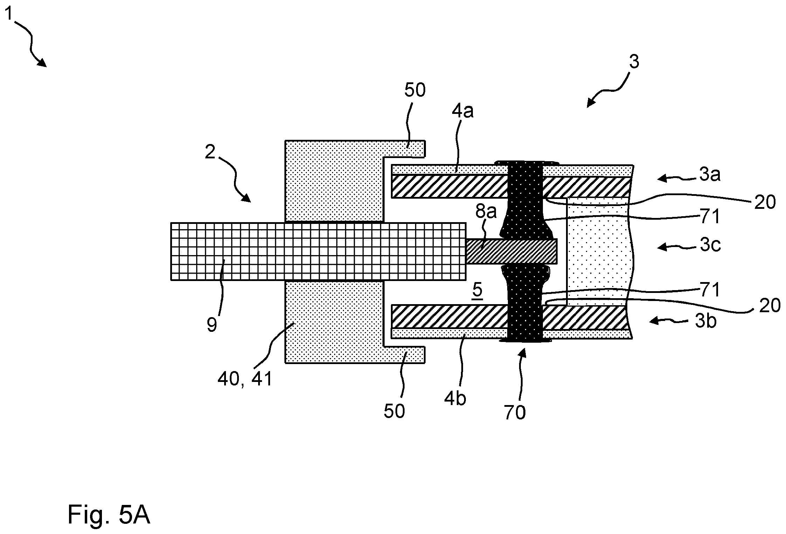

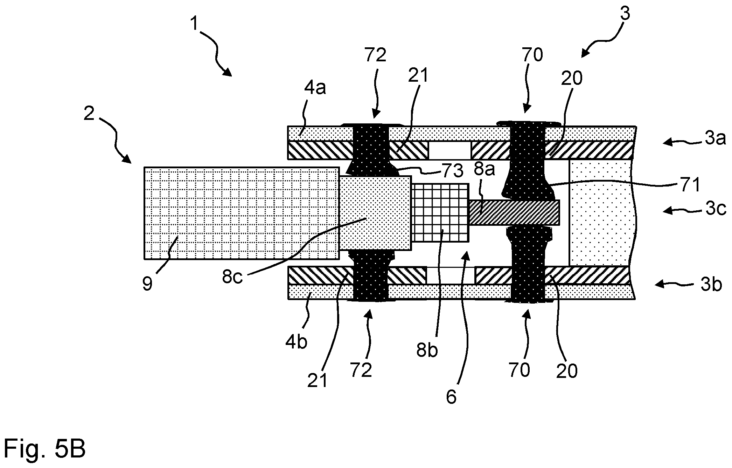

In den Figuren 5A und 5B wird dargestellt, wie das erste Leitersystem 8 die Leiterplattenordnung 3 kontaktiert. Es ist zumindest eine erste Innenleiterkontaktieröffnung 70 vorgesehen, die die erste und/oder zweite Außenlagenordnung 3a, 3b durchsetzt und in den Kabelaufnahmeraum 5 mündet. Die erste elektrisch leitfähige Innenleiteranordnung 8a des ersten Leitersystems 8 ist an dem ersten Seitenrand 6 in den Kabelaufnahmeraum 5 eingeführt und unter bzw. über der ersten Innenleiterkontaktieröffnung 70 angeordnet. Die elektrisch leitfähige Innenleiteranordnung 8a des ersten Leitersystems 8 ist dann über eine Innenleiterlötverbindung 71 zumindest im Bereich der ersten Innenleiterkontaktieröffnung 70 mit dem ersten Innenleiteranschlussbereich 20 der ersten und/oder zweiten Außenlageanordnung 3a, 3b der Leiterplattenanordnung 3 elektrisch leitfähig befestigt, insbesondere verlötet.

In Figur 5B ist eine erste Außenleiterkontaktieröffnung 72 gezeigt, die wie die erste Innenleiterkontaktieröffnung 70 in der Leiterplattenanordnung 3 angeordnet ist. Sie ist allerdings näher zum ersten Seitenrand 6 angeordnet als die erste Innenleiterkontaktieröffnung 70. Als Außenleiteranordnung des ersten Leitersystems 8 ist insbesondere die Schirmfolie 8c bzw. das nicht dargestellte Schirmdrahtgeflecht ausgebildet, beispielsweise durch entsprechende Kontaktierung oder Verschaltung. Über eine entsprechende erste Außenleiterlötverbindung 73 findet dann die elektrische Kontaktierung statt.

Gleiches würde auch für das zweite Leitersystem 11 bzw. jedes weitere Leitersystem gelten.

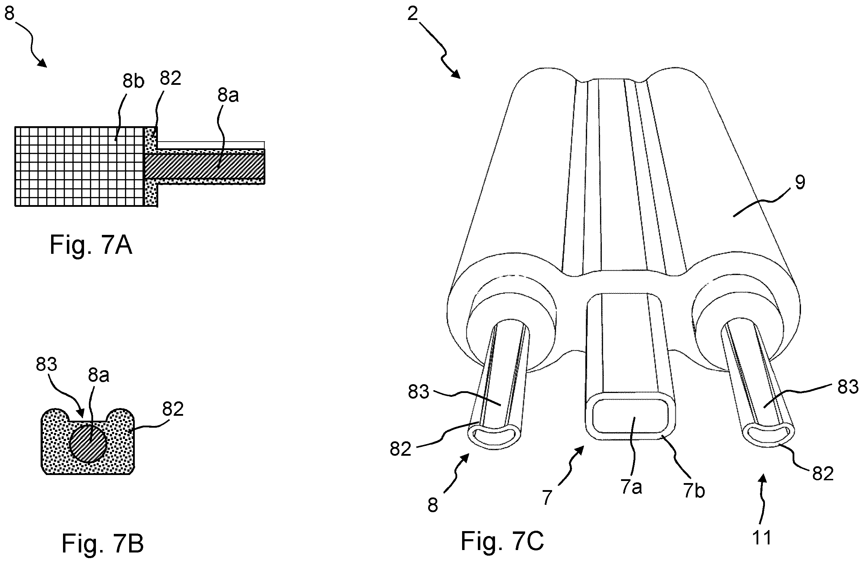

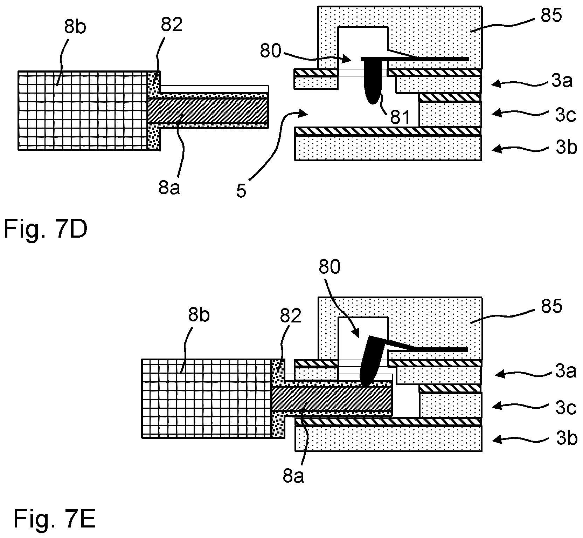

In den Figuren 7A, 7B, 7C, 7D und 7E ist ein erstes Ausführungsbeispiel dargestellt, mit dem die Innenleiteranordnung 8a lösbar mit der Leiterplattenanordnung 3 verbindbar ist. In diesem Fall umfasst die Leiterplattenanordnung 3 zumindest ein Federelement 80. Das Federelement 80 ist in einer Gehäuseanordnung 85 angeordnet, welche an der ersten oder zweiten Außenlageanordnung 3a, 3b aufliegt.

Das Federelement 80 weist einen Kontaktierungsvorsprung 81 auf, der von einer Oberseite des Federelements 80 absteht. Der Kontaktierungsvorsprung 81 des Federelements 80 taucht über eine Öffnung in der ersten oder zweiten Außenlageanordnung 3a, 3b in den Kabelaufnahmeraum 5 ein. In einer Ruhelage (Figur 7D) vor dem Einschieben der elektrisch leitfähigen Innenleiteranordnung 8a in den Kabelaufnahmeraum 5, steht der Kontaktierungsvorsprung 81 nicht in Kontakt mit der elektrisch leitfähigen Innenleiteranordnung 8a. In einer Kontaktierungslage (siehe Figur 7E), die nach dem Einschieben der Innenleiteranordnung 8a in den Kabelaufnahmeraum 5 vorliegt, gelangt der Kontaktierungsvorsprung 81 in galvanischen Kontakt mit der elektrisch leitfähigen Innenleiteranordnung 8a. In diesem Fall wird das Federelement 80 ausgelenkt und biegt sich von der Innenleiteranordnung 8a weg. In den Figuren 7D und 7E sind das Federelement 80 und der Kontaktierungsvorsprung 81 elektrisch leitfähig und vorzugsweise einteilig ausgebildet. Die elektrische Kontaktierung der Innenleiteranordnung 8a erfolgt in diesem Fall über den Kontaktierungsvorsprung 81 und das Federelement 80, das wiederum mit weiteren Elementen der Leiterplattenanordnung 3 elektrisch verbunden ist.

Der Kontaktierungsvorsprung 81 kann direkt die Innenleiteranordnung 8a des ersten Leitersystems 8 kontaktieren. Vorzugsweise umfasst die Hybridkabelanordnung 2 noch eine Innenleiterhülse 82, die auf die elektrisch leitfähige Innenleiteranordnung 8a des ersten Leitersystems 8 aufgepresst ist (siehe Figuren 7A bis 7C). Die Innenleiterhülse 82 hat bevorzugt die Form einer Aderendhülse. Der Durchmesser der Innenleiterhülse 82 ist an dem Ende größer, an dem die Innenleiterhülse 82 an dem elektrischen Mantel 8b des ersten Leitersystems 8 anliegt. Die Innenleiterhülse 82 weist einen wannenförmigen bzw. Uförmigen Querschnitt (siehe Figuren 7B, 7C) auf, wodurch über zumindest eine Teillänge in der Längsachse der Innenleiterhülse 82 ein Führungskanal 83 zur Aufnahme des Kontaktierungsvorsprungs 81 gebildet ist.

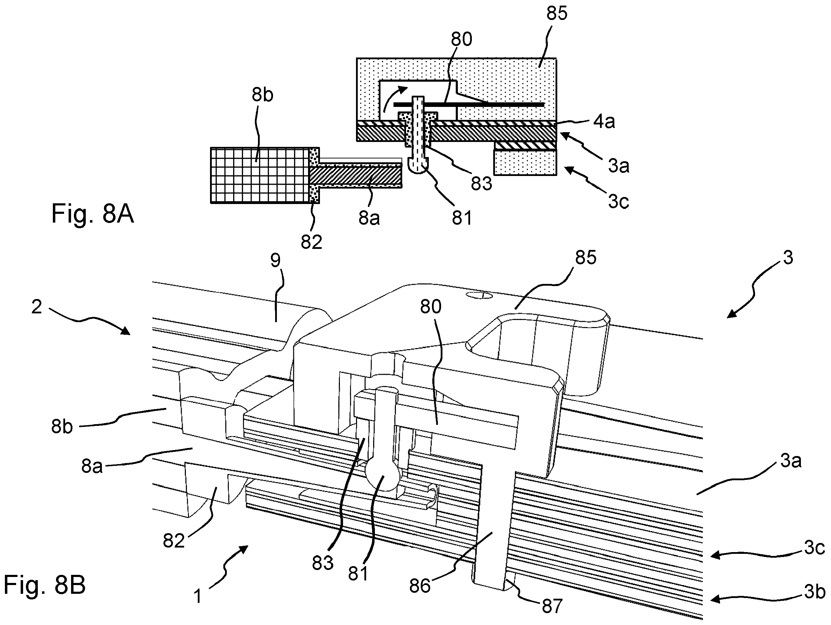

Ein anderes Ausführungsbeispiel wird in den Figuren 8A, 8B und 8C beschrieben. Der Kontaktierungsvorsprung 81 und das Federelement 80 sind zweiteilig ausgebildet, wobei der Kontaktierungsvorsprung 81 die Form eines Kontaktierungsbolzens hat. Der Bolzenkopf, der die Innenleiteranordnung 8a kontaktiert, hat einen größeren Durchmesser als der Bolzenhals. Der Kontaktierungsbolzen ist vorzugsweise in eine Öffnung des Federelements 80 eingepresst oder liegt an diesem an. Weiterhin ist eine Hülse 83 vorgesehen, die elektrisch leitfähig ist. Die Hülse 83 ist in der Öffnung in der ersten oder zweiten Außenlageanordnung 3a, 3b eingesetzt. Die Innenwandung der Öffnung ist dabei galvanisiert, sodass die Hülse 83 und die Innenwandung galvanisch kontaktiert sind. Der Kontaktierungsbolzen ist galvanisch mit der Hülse 83 verbunden und kann innerhalb dieser bewegt werden. Bewegt sich der Bolzenkopf in Richtung der Hülse 83, dann drückt das Ende des Bolzenhalses gegen das Federelement 80, wodurch das Federelement 80 eine Kraft auf dem Kontaktierungsbolzen ausübt. In Figur 8A, in welcher die Innenleiteranordnung 8a nicht eingeführt ist, drückt das Federelement 80 den Bolzenkopf des Kontaktierungsbolzens aus der Hülse 83 heraus. Wird die Innenleiteranordnung 8a eingeführt, so drückt diese den Bolzenkopf des Kontaktierungsbolzens in Richtung der Hülse 83, wodurch das Federelement 80 ausgelenkt wird. Die elektrische Verbindung zwischen Innenleiteranordnung 8a und Leiterplatte 3 findet dann über den Kontaktierungsbolzen und die Hülse 83 und die galvanisierte Innenwandung der Öffnung statt. Es wäre auch möglich, dass die Hülse 83 nicht fest in die Öffnung eingepresst, sondern in diese eingelegt ist. In diesem Fall sind Hülse 83, Kontaktierungsbolzen und das Federelement 80 vorzugsweise miteinander verpresst bzw. verschweißt. Bei Einführen der Innenleiteranordnung 8a wird die Hülse 83 teilweise aus der Öffnung herausbewegt. Dabei berührt sie nach wie vor die Innenwandung der Öffnung. Die Hülse 83 hat vorzugsweise Abschnitte mit unterschiedlichen Durchmessern, sodass ein Abschnitt einen flanschförmigen Vorsprung bildet, dessen Durchmesser größer ist als der Durchmesser der Öffnung, wodurch die Hülse 83 nicht durch diese hindurchfällt. Hülse 83, Kontaktierungsbolzen und Federelement 80 werden vor der Montage gemeinsam montiert. In Figur 8B ist die Kontaktierungslage im Schnitt durch die Anschlussverbindung 1 gezeigt. Figur 8C zeigt die Gehäuseanordnung 85 isoliert. Die Gehäuseanordnung 85 kann aus Metall oder Kunststoff bestehen oder solches umfassen. Die Gehäuseanordnung 85 ist vorzugsweise lediglich oder überwiegend nur in Richtung der Öffnung in der ersten oder zweiten Außenlageanordnung 3a, 3b geöffnet.

Die Gehäuseanordnung 85 kann an die Leiterplattenanordnung 3 in einem Kunststoffspritzverfahren angespritzt sein. Vorzugsweise umfasst die (insbesondere einteilige) Gehäuseanordnung 85 zumindest einen Befestigungsbolzen 86 (siehe Figuren 8B, 8C). Die Leiterplattenanordnung 3 umfasst zumindest eine Befestigungsöffnung, die die Leiterplattenanordnung 3 vollständig durchsetzt. Der zumindest eine Befestigungsbolzen 86 erstreckt sich von der Gehäuseanordnung 85 weg und durchsetzt die zumindest eine Befestigungsöffnung der Leiterplattenanordnung 3. Ein freies Ende des zumindest einen Befestigungsbolzen 86 ist gebogen und/oder verformt, sodass der Befestigungsbolzen 86 nach der Montage der Gehäuseanordnung 85 nicht mehr durch die zumindest eine Befestigungsöffnung bewegbar und die Gehäuseanordnung 85 abziehbar ist. Die Verformung kann insbesondere in einem Ultraschallschweißverfahren stattfinden, wodurch sich das freie Ende des Befestigungsbolzens 86 verformt und sich in seinem Durchmesser vergrößert.

Für die Kontaktierung der elektrisch leitfähigen Innenleiteranordnung des zweiten Leitsystems 11 umfasst die Leiterplattenanordnung 3 ein weiteres Federelement.

Figur 9 zeigt einen Leiterplattenverbund 90. Dieser Leiterplattenverbund 90 umfasst zwei Anschlussverbindungen 1, wobei jede Anschlussverbindung 1 eine Leiterplattenanordnung 3 und die Hybridkabelanordnung 2 umfasst. Auf jeder Leiterplattenanordnung 3 ist ein Computerchip 15 vorhanden. Beide Computerchips 15 kommunizieren über das dielektrische Wellenleitersystem 7 bidirektional miteinander. Über das erste Leitersystem 8 wird ein Strom von einer Leiterplattenanordnung 3 zur anderen Leiterplattenanordnung 3 über die Hybridkabelanordnung 2 übertragen. Über das zweite Leitersystem 11 findet die Masseanbindung einer Leiterplattenanordnung 3 an die andere Leiterplattenanordnung 3 statt. Wie zu erkennen ist, können durch Einsatz der erfindungsgemäßen Anschlussverbindung sehr kompakte Verbindungen zwischen einer Leiterplattenanordnung 3 und einem Hybridkabel 2 geschaffen werden.

Nachfolgend werden nochmals einige besonders vorteilhafte Ausgestaltungen der Anschlussverbindung 1 gesondert hervorgehoben.

Die Anschlussverbindung 1 weist bevorzugt das folgende Merkmal auf:
die Strahlerfläche 17 ist eine elektrisch leitfähige Lage 4d der Zwischenlageanordnung 3c oder ein separates Metallteil.

Die Anschlussverbindung 1 weist bevorzugt das folgende Merkmal auf:
die Ausnehmung 5 ist durch ein zerspanendes Verfahren in der Zwischenlageanordnung 3c gebildet; oder
die erste und die zweite Außenlageanordnung 3a, 3b stehen über die Zwischenlageanordnung 3c an dem ersten Seitenrand 6 über, wodurch die Ausnehmung 5 und dadurch der Kabelanschlussraum 5 gebildet sind.

Die Anschlussverbindung 1 weist bevorzugt die folgenden Merkmale auf:
das erste Leitersystem 8 der Hybridkabelanordnung 2 umfasst noch eine elektrisch leitfähige Außenleiteranordnung 8c, die von der Innenleiteranordnung 8a durch den Mantel 8b galvanisch getrennt ist;
zumindest eine erste Außenleiterkontaktieröffnung 72 durchsetzt die erste und/oder zweite Außenlageanordnung 3a, 3b und mündet in den Kabelaufnahmeraum 5;
die erste Außenleiterkontaktieröffnung 72 ist näher an dem ersten Seitenrand 6 angeordnet als die erste Innenleiterkontaktieröffnung 70;
die Außenleiteranordnung 8c des ersten Leitersystems 8 ist an dem ersten Seitenrand 6 in den Kabelaufnahmeraum 5 eingeführt und über bzw. unter der Außenleiterkontaktieröffnung 72 angeordnet;
die Außenleiteranordnung 8b des ersten Leitersystems 8 ist über eine erste Außenleiterlötverbindung 73 zumindest im Bereich der ersten Außenleiterkontaktieröffnung 72 mit einem ersten Außenleiteranschlussbereich 21 der ersten und/oder zweiten Außenlageanordnung 3a, 3b elektrisch leitfähig verlötet;
der erste Innenleiteranschlussbereich 20 ist galvanisch von dem ersten Außenleiteranschlussbereich 21 getrennt.

Die Anschlussverbindung 1 weist bevorzugt die folgenden Merkmale auf:
die Hybridkabelanordnung 2 umfasst ein zweites Leitersystem 11 zur Energie und/oder Datenübertragung;
das zweite Leitersystem 11 umfasst eine elektrisch leitfähige Innenleiteranordnung 11a, die von einem Mantel 11b umgeben ist;
das erste und zweite Leitersystem 8, 11 und das dielektrische Wellenleitersystem 7 sind parallel zueinander angeordnet;
zumindest eine zweite Innenleiterkontaktieröffnung durchsetzt die erste und/oder zweite Außenlageanordnung 3a, 3b mündet in den Kabelaufnahmeraum 5;
die elektrisch leitfähige Innenleiteranordnung 11a des zweiten Leitersystems 11 ist an dem ersten Seitenrand 6 in den Kabelaufnahmeraum 5 und unter bzw. über der zumindest einen zweiten Innenleiterkontaktieröffnung angeordnet;
die elektrisch leitfähige Innenleiteranordnung 11a des zweiten Leitersystems 11 ist über eine zweite Innenleiterlötverbindung zumindest im Bereich der zweiten Innenleiterkontaktieröffnung mit einem zweiten Innenleiteranschlussbereich der ersten und/oder zweiten Außenlageanordnung 3a, 3b elektrisch leitfähig verlötet;
der erste Innenleiteranschlussbereich und der zweite Innenleiteranschlussbereich sind galvanisch voneinander getrennt.

Auch für die elektrisch leitfähige Außenleiteranordnung 11c des zweiten Leitersystems 11 gelten dieselben Ausführungen wie für die elektrisch leitfähige Außenleiteranordnung 8c des ersten Leitersystems 8.

Die Anschlussverbindung 1 weist bevorzugt die folgenden Merkmale auf:
die Außenleiteranordnung 8c des ersten Leitersystems 8 umfasst ein Schirmdrahtgeflecht und/oder eine Schirmfolie; und/oder
die Innenleiteranordnung 8a des ersten Leitersystems 8 umfasst eine Vielzahl von Litzen oder einen Draht.

Die Anschlussverbindung 1 weist bevorzugt die folgenden Merkmale auf:
ein Ende des bolzenförmigen Kontaktierungsvorsprung 81 weist einen Bolzenkopf auf, der einen größeren Querschnitt aufweist als ein sich daran anschließender Bolzenhals und mit einer ersten Seite der Hülse 83 in Kontakt steht; und/oder
ein Bolzenhals des bolzenförmigen Kontaktierungsvorsprungs 81 durchsetzt sowohl die Hülse 83 als auch das Federelement 80 über eine entsprechende Öffnung.

Die Anschlussverbindung 1 weist bevorzugt das folgende Merkmal auf:
ein Ende des Bolzenhalses des Kontaktierungsvorsprungs 81 ist mit der Hülse 83 und dem Federelement 80 verpresst.

Die Anschlussverbindung 1 weist bevorzugt die folgenden Merkmale auf:
die Hülse 83 umfasst einen flanschförmigen Vorsprung, der einen größeren Durchmesser aufweist als die Öffnung in der ersten oder zweiten Außenlageanordnung 3a, 3b, sodass verhindert wird, dass die Hülse 83 durch die Öffnung fällt; und/oder
eine Innenwandung der Öffnung in der ersten oder zweiten Außenlageanordnung 3a, 3b ist galvanisiert, wodurch die Hülse 83 galvanisch mit der Innenwandung kontaktiert ist; und/oder
die Hülse 83 ist in die Öffnung eingepresst und beweglich in dieser geführt, wobei die Hülse 83 in der Kontaktierungslage weiter in Richtung der Gehäuseanordnung 85 aus der Öffnung heraussteht als in der Ruhelage.

Die Anschlussverbindung 1 weist bevorzugt noch das folgende Merkmal auf:
in der Gehäuseanordnung 85 ist zumindest ein weiteres Federelement 80 angeordnet.

Die Anschlussverbindung 1 weist bevorzugt noch die folgenden Merkmale auf:
die Befestigungseinrichtung 42 umfasst zumindest eine zweite Rastzunge 45;
die zweite Rastzunge 45 verläuft in Richtung einer Oberseite der Leiterplattenanordnung 3, wobei die Oberseite durch eine Oberfläche 4a, 4b der ersten oder zweiten Außenlageanordnung 3a, 3b gebildet ist;
die zweite Rastzunge 44 umfasst einen Rastvorsprung 45a, der in die erste Rastöffnung 47 über die andere Oberfläche 4b, 4a eingreift oder der Rastvorsprung greift in eine zweite Rastöffnung ein, die versetzt zur ersten Rastöffnung 47 an der Leiterplattenanordnung 3 angeordnet ist.

Die Anschlussverbindung 1 weist bevorzugt das folgende Merkmal auf:
die Farbe des Mantels 8b, 11b von zumindest zwei oder allen Leitersystemen 8, 11 ist unterschiedlich.

Die Anschlussverbindung 1 weist bevorzugt das folgende Merkmal auf:
es ist ein elektrisch nichtleitender Außenmantel 9 vorgesehen, der sowohl das zumindest eine dielektrische Wellenleitersystem 7 als auch das erste Leitersystem 8 bzw. zweite Leitersystem 11 gemeinsam umgibt.

Die Anschlussverbindung 1 weist bevorzugt das folgende Merkmal auf:
der Resonanzraum 16 ist mit einem dielektrischen Material gefüllt, wobei das Material für die Füllung:
a) dem Material des Kerns 7a des dielektrischen Wellenleitersystems 7 entspricht; und/oder
b) ein Kunststoff wie PE (Polyethylen) oder PP (Polypropylen) ist.

Die Anschlussverbindung 1 weist bevorzugt das folgende Merkmal auf:
das Material für die Füllung des Resonanzraums 16 ist ein Schaummaterial.

Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

## Patentansprüche

1. Anschlussverbindung (1) mit einer Hybridkabelanordnung (2) und einer Leiterplattenanordnung (3) mit den folgenden Merkmalen:
die Leiterplattenanordnung (3) umfasst eine erste Außenlageanordnung (3a), eine zweite Außenlageanordnung (3b) und eine Zwischenlageanordnung (3c), die aufeinander gestapelt angeordnet sind, wobei die Zwischenlageanordnung (3c) zwischen der ersten Außenlageanordnung (3a) und der zweiten Außenlageanordnung (3b) angeordnet ist;
die erste Außenlageanordnung (3a) umfasst zumindest eine Lage (4a) die elektrisch leitfähig ist;
die zweite Außenlageanordnung (3b) umfasst zumindest eine Lage (4b) die elektrisch leitfähig ist;
die Hybridkabelanordnung (2) umfasst zumindest ein dielektrisches Wellenleitersystem (7) zur Übertragung einer Radarwelle im Frequenzbereich von mehr als ca. 70 bis maximal ca. 300 GHz, insbesondere von ca. 80 bis ca. 150 GHz;
das zumindest eine dielektrische Wellenleitersystem (7) weist einen Kern (7a) und eine Hülle (7b) auf, wobei die Hülle (7b) den Kern (7a) umgibt;
die Hybridkabelanordnung (2) umfasst ein erstes Leitersystem (8) zur Energie und/oder Datenübertragung, wobei das erste Leitersystem (8) benachbart zu dem zumindest einen dielektrischen Wellenleitersystem (7) angeordnet ist;
das erste Leitersystem (8) umfasst eine elektrisch leitfähige Innenleiteranordnung (8a), die von einem Mantel (8b) umgeben ist;
**gekennzeichnet durch** die folgenden Merkmale:
die Leiterplattenanordnung (3) umfasst zwischen der ersten Außenlageanordnung (3a) und der zweiten Außenlageanordnung (3b) eine erste Ausnehmung (5), wodurch ein Kabelaufnahmeraum (5) an einem ersten Seitenrand (6) der Leiterplattenanordnung (3) gebildet ist;
die elektrisch leitfähige Innenleiteranordnung (8a) des ersten Leitersystems (8) ist an dem ersten Seitenrand (6) in den Kabelaufnahmeraum (5) eingeführt und mit einem ersten Innenleiteranschlussbereich (20) der Leiterplattenanordnung (3) galvanisch verbunden;
zumindest der Kern (7a) des zumindest einen dielektrischen Wellenleitersystems (7) ist an dem ersten Seitenrand (6) in den Kabelaufnahmeraum (5) eingeführt und an einem Wellenleiteranschlussbereich (30) der Leiterplattenanordnung (3) angeordnet.

2. Anschlussverbindung (1) nach Anspruch 1, **gekennzeichnet durch** die folgenden Merkmale:
die Leiterplattenanordnung (3) umfasst einen Computerchip (15), der dazu ausgebildet ist, um über das zumindest eine dielektrische Wellenleitersystem (7) zu kommunizieren;
die Leiterplattenanordnung (3) umfasst zwischen der ersten Außenlageanordnung (3a) und der zweiten Außenlageanordnung (3b) eine zweite Ausnehmung (16), wodurch ein Resonanzraum (16) gebildet ist;
der Resonanzraum (16) vergrößert sich von einem ersten Ende (16a) hin zu einem zweiten Ende (16b);
der Resonanzraum (16) ist nach oben hin zumindest durch die elektrisch leitfähige Lage (4a) der ersten Außenlageanordnung (3a) begrenzt;
der Resonanzraum (16) ist nach unten hin zumindest durch die elektrisch leitfähige Lage (4b) der zweiten Außenlageanordnung (3b) begrenzt;
der Resonanzraum (16) ist zu einer ersten und zu einer zweiten Seite hin durch eine erste Reihe von Durchkontaktierungen (19a) und durch eine zweite Reihe von Durchkontaktierungen (19b) begrenzt, wobei die Durchkontaktierungen (19a, 19b) mit der elektrisch leitfähigen Lage (4a, 4b) der ersten und zweiten Außenlageanordnung (3a, 3b) galvanisch verbunden sind;
der Computerchip (15) ist innerhalb der Leiterplattenanordnung (3) angeordnet.

3. Anschlussverbindung (1) nach Anspruch 2, **gekennzeichnet durch** die folgenden Merkmale:
an dem ersten Ende (16a) des Resonanzraums (16) ist eine Strahlerfläche (17) angeordnet, die in den Resonanzraum (16) hineinverläuft und die mit dem Computerchip (15) verbunden ist, wobei das zweite Ende (16b) des Resonanzraums (16) eine Durchgangsöffnung (18) zum Kabelaufnahmeraum (5) aufweist, wodurch der Wellenleiteranschlussbereich (30) gebildet ist;
der Kern (7a) des zumindest einen dielektrischen Wellenleitersystems (7) ist im Bereich der Durchgangsöffnung (18) angeordnet.

4. Anschlussverbindung (1) nach Anspruch 3, **gekennzeichnet durch** das folgende Merkmal:
der Computerchip (15) ist gehäuselos innerhalb der Leiterplattenanordnung (3) angeordnet und Bonddrähte (15a) verbinden einen Anschluss des Computerchips (15) mit einer Kontaktierungsfläche (17a) der Leiterplattenanordnung (3), die galvanisch mit der Strahlerfläche (17) verbunden ist.

5. Anschlussverbindung (1) nach einem der Ansprüche 2 bis 4, **gekennzeichnet durch** die folgenden Merkmale:
der Computerchip (15) ist in dem Resonanzraum (16) angeordnet; oder
die Leiterplattenanordnung (3) umfasst zwischen der ersten Außenlageanordnung (3a) und der zweiten Außenlageanordnung (3b) eine dritte Ausnehmung, wodurch ein Aufnahmeraum gebildet ist und wobei der Computerchip (15) in dem Aufnahmeraum angeordnet ist.

6. Anschlussverbindung (1) nach einem der vorherigen Ansprüche, **gekennzeichnet durch** die folgenden Merkmale:
zumindest eine erste Innenleiterkontaktieröffnung (70) durchsetzt die erste Außenlageanordnung (3a) und/oder die zweite Außenlageanordnung (3b) und mündet in den Kabelaufnahmeraum (5);
die elektrisch leitfähige Innenleiteranordnung (8a) des ersten Leitersystems (8) ist an dem ersten Seitenrand (6) in den Kabelaufnahmeraum (5) eingeführt und unter bzw. über der ersten Innenleiterkontaktieröffnung (70) angeordnet;
die elektrisch leitfähige Innenleiteranordnung (8a) des ersten Leitersystems (8) ist über eine erste Innenleiterlötverbindung (71) zumindest im Bereich der ersten Innenleiterkontaktieröffnung (70) mit dem ersten Innenleiteranschlussbereich (20) der ersten und/oder zweiten Außenlageanordnung (3a, 3b) der Leiterplattenanordnung (3) elektrisch leitfähig verlötet.

7. Anschlussverbindung (1) nach einem der Ansprüche 1 bis 5, **gekennzeichnet durch** die folgenden Merkmale:
die Leiterplattenanordnung (3) umfasst eine Gehäuseanordnung (85), in der zumindest ein Federelement (80) angeordnet ist;
die Gehäuseanordnung (85) liegt an der ersten oder zweiten Außenlageanordnung (3a, 3b) auf;
das Federelement (80) weist einen Kontaktierungsvorsprung (81) auf, der von einer Oberseite des Federelements (80) absteht;
der Kontaktierungsvorsprung (81) des Federelements (80) taucht über eine Öffnung in der ersten oder zweiten Außenlageanordnung (3a, 3b) in den Kabelaufnahmeraum (5) ein;
in einer Ruhelage vor Einschieben der elektrisch leitfähigen Innenleiteranordnung (8a) in den Kabelaufnahmeraum (5) steht der Kontaktierungsvorsprung (81) nicht in Kontakt zu der elektrisch leitfähigen Innenleiteranordnung (8a) des ersten Leitersystems (8);
in einer Kontaktierungslage bei Einschieben der elektrisch leitfähigen Innenleiteranordnung (8a) in den Kabelaufnahmeraum (5) gelangt der Kontaktierungsvorsprung (81) in galvanischen Kontakt mit der elektrisch leitfähigen Innenleiteranordnung (8a) des ersten Leitersystems (8) und das Federelement (80) wird ausgelenkt und biegt sich von der elektrisch leitfähigen Innenleiteranordnung (8a) des ersten Leitersystems (8) weg.

8. Anschlussverbindung (1) nach Anspruch 7, **gekennzeichnet durch** die folgenden Merkmale:
das Federelement (80) ist elektrisch leitfähig und der Kontaktierungsvorsprung (81) und das Federelement (80) sind einteilig ausgebildet, wobei der Kontaktierungsvorsprung (81) in das Federelement (80) tiefgeprägt ist; oder
der Kontaktierungsvorsprung (81) und das Federelement (80) sind zweiteilig ausgebildet, wobei der Kontaktierungsvorsprung (81) als Kontaktierungsbolzen ausgebildet ist; und:
a) in eine Öffnung des Federelements (80) eingepresst ist; und/oder
b) in einer Hülse (83) angeordnet ist, wobei die Hülse (83) in der Öffnung in der ersten oder zweiten Außenlageanordnung (3a, 3b) eingesetzt ist und wobei die Hülse (83) galvanisch mit einer elektrisch leitfähigen Lage (4a, 4b) der ersten oder zweiten Außenlageanordnung (3a, 3b) verbunden ist, wobei der Kontaktierungsbolzen galvanisch mit der Hülse (83) verbunden ist und wobei der Kontaktierungsbolzen in der Kontaktierungslage gegen das Federelement (80) drückt, wodurch sich das Federelement (80) von der elektrisch leitfähigen Innenleiteranordnung (8a) des ersten Leitersystems (8) weg biegt.

9. Anschlussverbindung (1) nach Anspruch 7 oder 8, **gekennzeichnet durch** die folgenden Merkmale:
die Hybridkabelanordnung (2) umfasst eine Innenleiterhülse (82), die auf die elektrisch leitfähige Innenleiteranordnung (8a) des ersten Leitersystems (8) aufgepresst ist;
die Innenleiterhülse (82) weist einen wannenförmigen bzw. uförmigen Querschnitt auf, wodurch über zumindest eine Teillänge in Längsachse der Innenleiterhülse (82) ein Führungskanal (83) zur Aufnahme des Kontaktierungsvorsprungs (81) gebildet ist;
der Kontaktierungsvorsprung (81) bewegt sich beim Einschieben der Hybridkabelanordnung (2) in dem Führungskanal (83) der Innenleiterhülse (82) entlang.

10. Anschlussverbindung (1) nach einem der Ansprüche 7 bis 9, **gekennzeichnet durch** die folgenden Merkmale:
die Gehäuseanordnung (85) umfasst zumindest einen Befestigungsbolzen (86);
die Leiterplattenanordnung (3) umfasst zumindest eine Befestigungsöffnung, die die Leiterplattenanordnung (3) vollständig durchsetzt;
der zumindest eine Befestigungsbolzen (86) erstreckt sich von der Gehäuseanordnung (85) weg und durchsetzt die zumindest eine Befestigungsöffnung der Leiterplattenanordnung (3);
ein freies Ende des zumindest einen Befestigungsbolzen (86) ist gebogen und/oder verformt, sodass der Befestigungsbolzen (86) nicht mehr durch die zumindest eine Befestigungsöffnung bewegbar ist, wodurch die Gehäuseanordnung (85) an der Leiterplattenanordnung (3) befestigt ist;
oder
die Leiterplattenanordnung (3) ist durch die die Gehäuseanordnung (85) umspritzt, wodurch die Gehäuseanordnung (85) an der Leiterplattenanordnung (3) befestigt ist.

11. Anschlussverbindung (1) nach einem der vorherigen Ansprüche, **gekennzeichnet durch** die folgenden Merkmale:
die Hybridkabelanordnung (2) umfasst eine Kabelsammel und Ausrichteinrichtung (40), die aus einem Kunststoff besteht oder einen solchen umfasst und einen Grundköper (41) aufweist;
die Kabelsammel und Ausrichteinrichtung (40) ist unverschiebbar an dem zumindest einen dielektrischen Wellenleitersystem (7) und dem ersten Leitersystem (8) angeordnet;
die Kabelsammel und Ausrichteinrichtung (40) umfasst zumindest eine Befestigungseinrichtung (42), die an dem Grundkörper (41) ausgebildet ist;
die Befestigungseinrichtung (42) ist dazu ausgebildet, die Kabelsammel und Ausrichteinrichtung (40) derart an der Leiterplattenanordnung (3) zu befestigen, dass das dielektrische Wellenleitersystem (7) und das erste Leitersystem (8) lageunveränderlich in dem Kabelaufnahmeraum (5) angeordnet sind;
die Befestigungseinrichtung (42) umfasst zumindest eine erste Rastzunge (44);
die zumindest eine erste Rastzunge (44) entspringt an dem Grundkörper (41) und ist federnd an diesem ausgebildet;
die zumindest eine erste Rastzunge (44) verläuft in Richtung einer Oberseite der Leiterplattenanordnung (3), wobei die Oberseite durch eine Oberfläche (4a, 4b) der ersten oder zweiten Außenlageanordnung (3a, 3b) gebildet ist;
eine erste Rastöffnung (47) durchsetzt die Leiterplattenanordnung (3);
die erste Rastzunge (44) umfasst einen Rastvorsprung (44a), der in die erste Rastöffnung (47) eingreift.

12. Anschlussverbindung (1) nach Anspruch 11, **gekennzeichnet durch** die folgenden Merkmale:
die Befestigungseinrichtung (42) umfasst zumindest ein erstes Halteelement (66), welches an dem Grundkörper (41) entspringt und in Richtung der Oberseite der Leiterplattenanordnung (3) verläuft;
die zumindest eine erste Rastzunge (44) ist in einer Ausnehmung des Halteelements (66) angeordnet und von dem zumindest einen ersten Halteelement (66) umgeben, wobei ein teilweise um die zumindest eine erste Rastzunge (44) umlaufender Schlitz (51) zwischen der zumindest einen ersten Rastzunge (44) und dem zumindest einen ersten Halteelement (66) ausgebildet ist, wodurch die zumindest eine erste Rastzunge (44) lediglich an dem Grundkörper (41) befestigt ist und gegenüber dem zumindest einen Halteelement (66) bewegbar ist.

13. Anschlussverbindung (1) nach Anspruch 11 oder 12, **gekennzeichnet durch** die folgenden Merkmale:
an dem Grundkörper (41) ist zumindest ein Zentrierungssteg (55) ausgebildet, der von dem Grundkörper (41) aus in Richtung der Leiterplattenanordnung (3) verläuft und in dem Kabelaufnahmeraum (5) endet;
der zumindest eine Zentrierungssteg (55) ist zwischen dem zumindest einen dielektrischen Wellenleitersystem (7) und dem ersten Leitersystem (8) angeordnet.

## Claims

1. Connection (1) with a hybrid cable arrangement (2) and a circuit board arrangement (3), having the following features:
the circuit board arrangement (3) comprises a first outer layer arrangement (3a), a second outer layer arrangement (3b) and an intermediate layer arrangement (3c), which are stacked on one another, wherein the intermediate layer arrangement (3c) is arranged between the first outer layer arrangement (3a) and the second outer layer arrangement (3b);
the first outer layer arrangement (3a) comprises at least one layer (4a) which is electrically conductive;
the second outer layer arrangement (3b) comprises at least one layer (4b) which is electrically conductive;
the hybrid cable arrangement (2) comprises at least one dielectric waveguide system (7) for the transmission of a radar wave in the frequency range from more than about 70 to a maximum of about 300 GHz, in particular from about 80 to about 150 GHz;
the at least one dielectric waveguide system (7) has a core (7a) and a sleeve (7b), wherein the sleeve (7b) surrounds the core (7a);
the hybrid cable arrangement (2) comprises a first conductor system (8) for the transmission of energy and/or data, wherein the first conductor system (8) is arranged adjacent to the at least one dielectric waveguide system (7);
the first conductor system (8) comprises an electrically conductive inner conductor arrangement (8a), which is surrounded by a sheath (8b);
**characterized by** the following features:
the circuit board arrangement (3) comprises a first recess (5) between the first outer layer arrangement (3a) and the second outer layer arrangement (3b), as a result of which a cable receiving space (5) is formed on a first side edge (6) of the circuit board arrangement (3);
the electrically conductive inner conductor arrangement (8a) of the first conductor system (8) is inserted into the cable receiving space (5) at the first side edge (6) and galvanically connected to a first inner conductor connection region (20) of the circuit board arrangement (3);
at least the core (7a) of the at least one dielectric waveguide system (7) is inserted into the cable receiving space (5) at the first side edge (6) and arranged on a waveguide connection region (30) of the circuit board arrangement (3).

2. Connection (1) according to Claim 1, **characterized by** the following features:
the circuit board arrangement (3) comprises a computer chip (15), which is designed to communicate via the at least one dielectric waveguide system (7);
the circuit board arrangement (3) comprises a second recess (16) between the first outer layer arrangement (3a) and the second outer layer arrangement (3b), as a result of which a resonant cavity (16) is formed;
the resonant cavity (16) enlarges from a first end (16a) towards a second end (16b);
the resonant cavity (16) is bounded towards the top at least by the electrically conductive layer (4a) of the first outer layer arrangement (3a);
the resonant cavity (16) is bounded towards the bottom at least by the electrically conductive layer (4b) of the second outer layer arrangement (3b);
the resonant cavity (16) is bounded towards a first and towards a second side by a first row of vias (19a) and by a second row of vias (19b), wherein the vias (19a, 19b) are galvanically connected to the electrically conductive layer (4a, 4b) of the first and second outer layer arrangement (3a, 3b);
the computer chip (15) is arranged within the circuit board arrangement (3).

3. Connection (1) according to Claim 2, **characterized by** the following features:
an emitter surface (17) is arranged at the first end (16a) of the resonant cavity (16), extends into the resonant cavity (16) and is connected to the computer chip (15), wherein the second end (16b) of the resonant cavity (16) has a passage opening (18) to the cable receiving space (5), as a result of which the waveguide connection region (30) is formed;
the core (7a) of the at least one dielectric waveguide system (7) is arranged in the region of the passage opening (18).

4. Connection (1) according to Claim 3, **characterized by** the following feature;
the computer chip (15) is arranged within the circuit board arrangement (3) without a housing, and bonding wires (15a) connect a terminal of the computer chip (15) to a contacting surface (17a) of the circuit board arrangement (3), the contacting surface being galvanically connected to the emitter surface (17).

5. Connection (1) according to one of Claims 2 to 4, **characterized by** the following features:
the computer chip (15) is arranged in the resonant cavity (16); or
the circuit board arrangement (3) comprises a third recess between the first outer layer arrangement (3a) than the second outer layer arrangement (3b), as a result of which a receiving space is formed and wherein the computer chip (15) is arranged in the receiving space.

6. Connection (1) according to one of the preceding claims, **characterized by** the following features:
at least one first inner conductor contact opening (70) passes through the first outer layer arrangement (3a) and/or the second outer layer arrangement (3b) and opens into the cable receiving space (5);
the electrically conductive inner conductor arrangement (8a) of the first conductor system (8) is inserted into the cable receiving space (5) at the first side edge (6) and arranged below or above the first inner conductor contact opening (70);
the electrically conductive inner conductor arrangement (8a) of the first conductor system (8) is electrically conductively soldered to the first inner conductor connection region (20) of the first and/or second outer layer arrangement (3a, 3b) of the circuit board arrangement (3) via a first inner conductor soldered connection (71), at least in the region of the first inner conductor contact opening (70).

7. Connection (1) according to one of Claims 1 to 5, **characterized by** the following features:
the circuit board arrangement (3) comprises a housing arrangement (85), in which at least one spring element (80) is arranged;
the housing arrangement (85) rests on the first or second outer layer arrangement (3a, 3b);
the spring element (80) has a contact-making projection (81) which protrudes from an upper side of the spring element (80);
the contact-making projection (81) of the spring element (80) dips into the cable receiving space (5) via an opening in the first or second outer layer arrangement (3a, 3b);
in a rest position, before the insertion of the electrically conductive inner conductor arrangement (8a) into the cable receiving space (5), the contact-making projection (81) is not in contact with the electrically conductive inner conductor arrangement (8a) of the first conductor system (8);
in a contacting position, as the electrically conductive inner conductor arrangement (8a) is inserted into the cable receiving space (5), the contact-making projection (81) comes into galvanic contact with the electrically conductive inner conductor arrangement (8a) of the first conductor system (8) and the spring element (80) is deflected and bends away from the electrically conductive inner conductor arrangement (8a) of the first conductor system (8).

8. Connection (1) according to Claim 7, **characterized by** the following features:
the spring element (80) is electrically conductive and the contact-making projection (81) and the spring element (80) are formed in one piece, the contact-making projection (81) being deeply embossed into the spring element (80); or
the contact-making projection (81) and the spring element (80) are formed in two parts, the contact-making projection (81) being formed as a contact-making pin; and:
a) being pressed into an opening of the spring element (80); and/or
b) being arranged in a sleeve (83), wherein the sleeve (83) is inserted into the opening in the first or second outer layer arrangement (3a, 3b), and wherein the sleeve (83) is galvanically connected to an electrically conductive layer (4a, 4b) of the first or second outer layer arrangement (3a, 3b), wherein the contact-making pin is galvanically connected to the sleeve (83), and wherein the contact-making pin presses against the spring element (80) when in the contact-making position, as a result of which the spring element (80) bends away from the electrically conductive inner conductor arrangement (8a) of the first conductor system (8).

9. Connection (1) according to Claim 7 or 8, **characterized by** the following features:
the hybrid cable arrangement (2) comprises an inner conductor sleeve (82), which is pressed onto the electrically conductive inner conductor arrangement (8a) of the first conductor system (8);
the inner conductor sleeve (82) has a trough-like or U-shaped cross section, as a result of which a guide channel (83) for receiving the contact-making projection (81) is formed over at least a partial length in the longitudinal axis of the inner conductor sleeve (82);
the contact-making projection (81) moves along in the guide channel (83) of the inner conductor sleeve (82) as the hybrid cable arrangement (2) is inserted.

10. Connection (1) according to one of Claims 7 to 9, **characterized by** the following features:
the housing arrangement (85) comprises at least one securing pin (86);
the circuit board arrangement (3) comprises at least one securing opening, which passes completely through the circuit board arrangement (3);
the at least one securing pin (86) extends away from the housing arrangement (85) and passes through the at least one securing opening of the circuit board arrangement (3);
a free end of the at least one securing pin (86) is bent and/or deformed, so that the securing pin (86) can no longer be moved through the at least one securing opening, as a result of which the housing arrangement (85) is secured to the circuit board arrangement (3);
or
the circuit board arrangement (3) is over-moulded by the housing arrangement (85), as a result of which the housing arrangement (85) is secured to the circuit board arrangement (3).

11. Connection (1) according to one of the preceding claims, **characterized by** the following features:
the hybrid cable arrangement (2) comprises a cable collecting and aligning device (40), which consists of a plastic or comprises such a plastic and has a main body (41);
the cable collecting and aligning device (40) is arranged non-displaceably on the at least one dielectric waveguide system (7) and the first conductor system (8);
the cable collecting and aligning device (40) comprises at least one securing device (42), which is formed on the main body (41);
the securing device (42) is designed to secure the cable collecting and aligning device (40) to the circuit board arrangement (3) in such a way that the dielectric waveguide system (7) and the first conductor system (8) are arranged in a fixed position in the cable receiving space (5);
the securing device (42) comprises at least one first latching tongue (44);
the at least one first latching tongue (44) originates on the main body (41) and is formed resiliently on the latter;
the at least one first latching tongue (44) extends in the direction of an upper side of the circuit board arrangement (3), wherein the upper side is formed by a surface (4a, 4b) of the first or second outer layer arrangement (3a, 3b);
a first latching opening (47) passes through the circuit board arrangement (3);
the first latching tongue (44) comprises a latching projection (44a) which engages in the first latching opening (47).

12. Connection (1) according to Claim 11, **characterized by** the following features:
the securing device (42) comprises at least one first holding element (66), which originates on the main body (41) and extends in the direction of the upper side of the circuit board arrangement (3);
the at least one first latching tongue (44) is arranged in a recess in the holding element (66) and surrounded by the at least one first holding element (66), wherein a slot (51) running partially around the at least one first latching tongue (44) is formed between the at least one first latching tongue (44) and the at least one first holding element (66), as a result of which the at least one first latching tongue (44) is secured only to the main body (41) and is movable with respect to the at least one holding element (66).

13. Connection (1) according to Claim 11 or 12, **characterized by** the following features:
at least one centring web (55) is formed on the main body (41), extends out from the main body (41) in the direction of the circuit board arrangement (3) and ends in the cable receiving space (5);
the at least one centring web (55) is arranged between the at least one dielectric waveguide system (7) and the first conductor system (8).

## Revendications

1. Connexion (1) comprenant un ensemble formant câble hybride (2) et un ensemble formant carte de circuit imprimé (3), ladite connexion présentant les caractéristiques suivantes :
l'ensemble formant carte de circuit imprimé (3) comprend un premier ensemble formant couche extérieure (3a), un deuxième ensemble formant couche extérieure (3b) et un ensemble formant couche intermédiaire (3c), lesquels sont empilés les uns sur les autres, l'ensemble formant couche intermédiaire (3c) étant disposé entre le premier ensemble formant couche extérieure (3a) et le deuxième ensemble formant couche extérieure (3b) ;
le premier ensemble formant couche extérieure (3a) comprend au moins une couche (4a) qui est électriquement conductrice ;
le deuxième ensemble formant couche extérieure (3b) comprend au moins une couche (4b) qui est électriquement conductrice ;
l'ensemble formant câble hybride (2) comprend au moins un système guide d'ondes diélectrique (7) destiné à transmettre une onde radar dans la gamme de fréquences allant d'environ 70 GHz minimum à environ 300 GHz maximum, en particulier d'environ 80 GHz à environ 150 GHz ;
l'au moins un système guide d'ondes diélectrique (7) comporte une âme (7a) et une gaine (7b), la gaine (7b) entourant l'âme (7a) ;
l'ensemble formant câble hybride (2) comprend un premier système conducteur (8) destiné à la transmission d'énergie et/ou de données, le premier système conducteur (8) étant disposé de manière adjacente à l'au moins un système guide d'ondes diélectrique (7) ;
le premier système conducteur (8) comprend un ensemble formant conducteur intérieur électriquement conducteur (8a) qui est entouré par une enveloppe (8b) ;
**caractérisée par** les caractéristiques suivantes :
l'ensemble formant carte de circuit imprimé (3) comprend entre le premier ensemble formant couche extérieure (3a) et le deuxième ensemble formant couche extérieure (3b) un premier évidement (5) qui forme un espace de réception de câble (5) sur un premier bord latéral (6) de l'ensemble formant carte de circuit imprimé (3) ;
l'ensemble formant conducteur intérieur électriquement conducteur (8a) du premier système conducteur (8) est introduit dans l'espace de réception de câble (5) au niveau du premier bord latéral (6) et est relié galvaniquement à une première zone de connexion de conducteur intérieur (20) de l'ensemble formant carte de circuit imprimé (3) ;
au moins l'âme (7a) de l'au moins un système guide d'ondes diélectrique (7) est insérée dans l'espace de réception de câble (5) au niveau du premier bord latéral (6) et est disposée au niveau d'une zone de connexion de guide d'ondes (30) de l'ensemble formant carte de circuit imprimé (3).

2. Connexion (1) selon la revendication 1, **caractérisée par** les caractéristiques suivantes :
l'ensemble formant carte de circuit imprimé (3) comprend une puce informatique (15) qui est conçue pour communiquer par le biais de l'au moins un système guide d'ondes diélectrique (7) ;
l'ensemble formant carte de circuit imprimé (3) comprend entre le premier ensemble formant couche extérieure (3a) et le deuxième ensemble formant couche extérieure (3b) un deuxième évidement (16) qui forme une cavité résonante (16) ;
la cavité résonante (16) s'agrandit d'une première extrémité (16a) à une deuxième extrémité (16b) ;
la cavité résonante (16) est délimitée en haut au moins par la couche électriquement conductrice (4a) du premier ensemble formant couche extérieure (3a) ;
la cavité résonante (16) est délimitée en bas au moins par la couche électriquement conductrice (4b) du deuxième ensemble formant couche extérieure (3b) ;
la cavité résonante (16) est délimitée sur un premier et un deuxième côté par une première rangée de contacts traversants (19a) et par une deuxième rangée de contacts traversants (19b), les contacts traversants (19a, 19b) étant reliés galvaniquement à la couche électriquement conductrice (4a, 4b) des premier et deuxième ensembles formant couche extérieure (3a, 3b) ;
la puce informatique (15) est disposée à l'intérieur de l'ensemble formant carte de circuit imprimé (3).

3. Connexion (1) selon la revendication 2, **caractérisée par** les caractéristiques suivantes :
une surface rayonnante (17) est disposée à la première extrémité (16a) de la cavité résonante (16), laquelle surface rayonnante s'étend jusque dans la cavité résonante (16) et est reliée à la puce informatique (15), la deuxième extrémité (16b) de la cavité résonante (16) comportant une ouverture traversante (18) menant vers l'espace de réception de câble (5) et permettant de former la zone de connexion de guide d'ondes (30) ;
l'âme (7a) de l'au moins un système guide d'ondes diélectrique (7) est disposée dans la zone de l'ouverture traversante (18).

4. Connexion (1) selon la revendication 3, **caractérisée par** la caractéristique suivante :
la puce informatique (15) est disposée sans boîtier à l'intérieur de l'ensemble formant carte de circuit imprimé (3) et des fils de liaison (15a) relient une borne de la puce informatique (15) à une surface de contact (17a) de l'ensemble formant carte de circuit imprimé (3) qui est reliée galvaniquement à la surface rayonnante (17).

5. Connexion (1) selon l'une des revendications 2 à 4, **caractérisée par** les caractéristiques suivantes :
la puce informatique (15) est disposée dans la cavité résonante (16) ; ou
l'ensemble formant carte de circuit imprimé (3) comprend entre le premier ensemble formant couche extérieure (3a) et le deuxième ensemble formant couche extérieure (3b) un troisième évidement qui forme un espace de réception et la puce informatique (15) étant disposée dans l'espace de réception.

6. Connexion (1) selon l'une des revendications précédentes, **caractérisée par** les caractéristiques suivantes :
au moins une première ouverture de contact de conducteur intérieur (70) traverse le premier ensemble formant couche extérieure (3a) et/ou le deuxième ensemble formant couche extérieure (3b) et débouche dans l'espace de réception de câble (5) ;
l'ensemble formant conducteur intérieur électriquement conducteur (8a) du premier système conducteur (8) est introduit dans l'espace de réception de câble (5) au niveau du premier bord latéral (6) et est disposé au-dessous ou au-dessus de la première ouverture de contact de conducteur intérieur (70) ;
l'ensemble formant conducteur intérieur électriquement conducteur (8a) du premier système conducteur (8) est soudé de manière électriquement conductrice à la première zone de connexion de conducteur intérieur (20) du premier et/ou du deuxième ensemble formant couche extérieure (3a, 3b) de l'ensemble formant carte de circuit imprimé (3) par le biais d'une première liaison soudée de conducteur intérieur (71) au moins dans la zone de la première ouverture de contact de conducteur intérieur (70).

7. Connexion (1) selon l'une des revendications 1 à 5, **caractérisée par** les caractéristiques suivantes :
l'ensemble formant carte de circuit imprimé (3) comprend un ensemble formant boîtier (85) dans lequel est disposé au moins un élément à ressort (80) ;
l'ensemble formant boîtier (85) recouvre le premier ou le deuxième ensemble formant couche extérieure (3a, 3b) ;
l'élément à ressort (80) comporte une saillie de contact (81) qui dépasse d'un côté supérieur de l'élément à ressort (80) ;
la saillie de contact (81) de l'élément à ressort (80) pénètre dans l'espace de réception de câble (5) par une ouverture ménagée dans le premier ou le deuxième ensemble formant couche extérieure (3a, 3b) ;
dans une position de repos avant que l'ensemble formant conducteur intérieur électriquement conducteur (8a) ne soit poussé dans l'espace de réception de câble (5), la saillie de contact (81) n'est pas en contact avec l'ensemble formant conducteur intérieur électriquement conducteur (8a) du premier système conducteur (8) ;
dans une position de contact lorsque l'ensemble formant conducteur intérieur électriquement conducteur (8a) est poussé dans l'espace de réception de câble (5), la saillie de contact (81) entre en contact galvanique avec l'ensemble formant conducteur intérieur électriquement conducteur (8a) du premier conducteur (8) et l'élément à ressort (80) est dévié et s'écarte de l'ensemble formant conducteur intérieur électriquement conducteur (8a) du premier système conducteur (8).

8. Connexion (1) selon la revendication 7, **caractérisée par** les caractéristiques suivantes :
l'élément à ressort (80) est électriquement conducteur et la saillie de contact (81) et l'élément à ressort (80) sont conçus d'une seule pièce, la saillie de contact (81) étant estampée profond dans l'élément à ressort (80) ; ou
la saillie de contact (81) et l'élément à ressort (80) sont conçus en deux parties, la saillie de contact (81) étant conçue comme un boulon de contact ; et :
a) étant enfoncée dans une ouverture de l'élément à ressort (80) ; et/ou
b) étant disposée dans un manchon (83), le manchon (83) étant inséré dans l'ouverture dans le premier ou le deuxième ensemble formant couche extérieure (3a, 3b) et le manchon (83) étant relié galvaniquement à une couche électriquement conductrice (4a, 4b) du premier ou du deuxième ensemble formant couche extérieure (3a, 3b), le boulon de contact étant relié galvaniquement au manchon (83) et le boulon de contact appuyant dans la position de contact contre l'élément à ressort (80) de sorte que l'élément à ressort (80) se plie en s'écartant de l'ensemble formant conducteur intérieur électriquement conducteur (8a) du premier système conducteur (8).

9. Connexion (1) selon la revendication 7 ou 8, **caractérisée par** les caractéristiques suivantes :
l'ensemble formant câble hybride (2) comprend un manchon de conducteur intérieur (82) qui est pressé sur l'ensemble formant conducteur intérieur électriquement conducteur (8a) du premier système conducteur (8) ;
le manchon conducteur intérieur (82) a une section transversale en forme d'auge ou en forme de U de façon à former un canal de guidage (83) destiné à recevoir la saillie de contact (81) sur au moins une partie de la longueur de l'axe longitudinal du manchon de conducteur intérieur (82) ;
la saillie de contact (81) se déplace le long du manchon de conducteur intérieur (82) lorsque l'ensemble formant câble hybride (2) est enfoncé dans le canal de guidage (83).

10. Connexion (1) selon l'une des revendications 7 à 9, **caractérisée par** les caractéristiques suivantes :
l'ensemble formant boîtier (85) comprend au moins un boulon de fixation (86) ;
l'ensemble formant carte de circuit imprimé (3) comprend au moins une ouverture de fixation qui traverse complètement l'ensemble formant carte de circuit imprimé (3) ;
l'au moins un boulon de fixation (86) s'étend en s'écartant de l'ensemble formant boîtier (85) et traverse l'au moins une ouverture de fixation de l'ensemble formant carte de circuit imprimé (3) ;
une extrémité libre de l'au moins un boulon de fixation (86) est pliée et/ou déformée de sorte que le boulon de fixation (86) ne puisse plus être déplacé à travers l'au moins une ouverture de fixation de sorte que l'ensemble formant boîtier (85) est fixé à l'ensemble formant carte de circuit imprimé (3) ;
ou
l'ensemble formant carte de circuit imprimé (3) est surmoulé par l'ensemble formant boîtier (85) de sorte que l'ensemble formant boîtier (85) est fixé à l'ensemble formant carte de circuit imprimé (3).

11. Connexion (1) selon l'une des revendications précédentes, **caractérisée par** les caractéristiques suivantes :
l'ensemble formant câble hybride (2) comprend un dispositif de rassemblement et d'alignement de câble (40) qui est en matière plastique ou qui comprend de la matière plastique et qui comporte un corps de base (41) ;
le dispositif de rassemblement et d'alignement de câble (40) est disposé sans pouvoir coulisser sur l'au moins un système guide d'ondes diélectrique (7) et le premier système conducteur (8) ;
le dispositif de rassemblement et d'alignement de câble (40) comprend au moins un dispositif de fixation (42) qui est formé sur le corps de base (41) ;
le dispositif de fixation (42) est conçu pour fixer le dispositif de rassemblement et d'alignement de câble (40) à l'ensemble formant carte de circuit imprimé (3) de manière que le système guide d'ondes diélectrique (7) et le premier système conducteur (8) soient disposés dans l'espace de réception de câble (5) sans pouvoir changer de position ;
le dispositif de fixation (42) comprend au moins une première languette d'encliquetage (44) ;
l'au moins une première languette d'encliquetage (44) prend naissance sur le corps de base (41) et est conçue élastiquement sur celuici ;
l'au moins une première languette d'encliquetage (44) s'étend en direction d'un côté supérieur de l'ensemble formant carte de circuit imprimé (3), le côté supérieur étant formé par une surface (4a, 4b) du premier ou du deuxième ensemble formant couche extérieure (3a, 3b) ;
une première ouverture d'encliquetage (47) traverse l'ensemble formant carte de circuit imprimé (3) ;
la première languette d'encliquetage (44) comprend une saillie d'encliquetage (44a) qui s'engage dans la première ouverture d'encliquetage (47).

12. Connexion (1) selon la revendication 11, **caractérisée par** les caractéristiques suivantes :
le dispositif de fixation (42) comprend au moins un premier élément de retenue (66) qui prend naissance sur le corps de base (41) et qui s'étend en direction du côté supérieur de l'ensemble formant carte de circuit imprimé (3) ;
l'au moins une première languette d'encliquetage (44) est disposée dans un évidement de l'élément de retenue (66) et est entourée par l'au moins un premier élément de retenue (66), une fente (51) qui entoure partiellement l'au moins une première languette d'encliquetage (44) étant formée entre l'au moins une première languette d'encliquetage (44) et l'au moins un premier élément de retenue (66) de sorte que l'au moins une première languette d'encliquetage (44) est fixée uniquement sur le corps de base (41) et est mobile par rapport à l'au moins un élément de retenue (66).

13. Connexion (1) selon la revendication 11 ou 12, **caractérisée par** les caractéristiques suivantes :
au moins une nervure de centrage (55) est formée sur le corps de base (41), laquelle s'étend depuis le corps de base (41) en direction de l'ensemble formant carte de circuit imprimé (3) et se termine dans l'espace de réception de câble (5) ;
l'au moins une nervure de centrage (55) est disposée entre l'au moins un système guide d'ondes diélectrique (7) et le premier système conducteur (8).
